# EUROPEAN PATENT APPLICATION

(11) **EP 2 042 340 A2**
(43) Date of publication of application: **01.04.2009**
(21) Application number: 08017053.3
(22) Date of filing: 26.09.2008
(51) Int. Cl.: B41N 3/08, C09D 171/02

(54) **Lithographic printing plate surface protective agent and platemaking method for lithographic printing plate**

(30) Priority: 27.09.2007 JP 2007251788
(71) Applicant: Fujifilm Corporation, Tokyo 106-8620 (JP)
(72) Inventor: Sakamoto, Atsushi, Shizuoka (JP)
(74) Representative: HOFFMANN EITLE

(57) **Abstract**

A lithographic printing plate surface protective agent is provided, which exhibits an excellent capacity to prevent fingerprint scumming on a post-platemaking lithographic printing plate. This lithographic printing plate surface protective agent comprises at least one compound represented by the following general formula (I)

R-O-(CH₂CH₂O)ₙ-H (I)

(in the formula, R is a C₁₄ to C₂₂ alkyl group and n is the average number of moles of addition of an ethylene oxide group and is 20 to 60).

## Description

### BACKGROUND OF THE INVENTION

### Field of the Invention

The present invention relates to a plate surface protective agent used in the platemaking of lithographic printing plates and to a platemaking method that uses this plate surface protective agent.

### Description of the Related Art

A so-called gum solution is applied in the final step of lithographic printing plate platemaking. The purpose of applying the gum solution is not only to protect the hydrophilicity of the non-image areas, but also to protect from scratching and to prevent scumming caused by the attachment of fingerprints, oil, dirt, and so forth during image correction (e.g., additions to or corrective deletions from the image area), during storage in the time interval after platemaking up to printing or storage until re-use, during installation in the press, and during handling. Another purpose is to provide a so-called desensitization treatment, e.g., to prevent the occurrence of oxidation scumming.

Aqueous solutions comprising gum arabic, cellulose gum, or a carboxyl-functional water-soluble polymer compound and, for example, various surfactants, acids, bases, organic solvents, oleophilic substances, inorganic salts, complexing agents, preservatives, defoamers, and so forth, have heretofore generally been used as the gum solutions for lithographic printing plates.

The gum solution-coated lithographic printing plate is stored until sent to printing. The number of printed sheets required after the start of printing to obtain a normal impression is known to vary substantially as a function of these storage conditions. Thus, for storage at low temperatures and low humidities, as in the winter in Japan, a normal impression is obtained after an unproblematic number of sheets have been printed; however, storage at high temperatures and high humidities, as in the summer, results in an increase in the number of printed sheets required until a normal impression is obtained. In particular, fingerprinting on the plate surface is prone to occur during handling of the plate after application of the gum solution. When the plate is then stored for some period of time at high humidity, the residual traces from any applied fingerprints print to give so-called fingerprint scumming; this has been a major cause of the increase in the number of printed sheets required to obtain a normal impression.

Water-soluble resins, various surfactants, and so forth have generally been used as the antiscumming agents in gum solutions (refer, for example, to Japanese Patent Application Publication Nos. S58-175695A and H7-52577A); however, a component specifically effective for preventing fingerprint scumming was heretofore unknown.

### DISCLOSURE OF THE INVENTION

### Problem to be solved by the Invention

An object of the present invention is to provide a plate surface protective agent for lithographic printing plates, wherein the plate surface protective agent exhibits an excellent capacity to prevent fingerprint scumming on post-platemaking lithographic printing plates.

### Means to Solve the Problem

As a result of intensive and extensive investigations in order to achieve the aforementioned object, the present inventor discovered that an excellent capacity to prevent fingerprint scumming can be developed by incorporating a special compound in the lithographic printing plate surface protective agent. The present invention was achieved based on this discovery.

Accordingly, the present invention is a plate surface protective agent for lithographic printing plates, the plate surface protective agent comprising at least one compound represented by the following general formula (I):

R-O-(CH₂CH₂O)ₙ-H (I)

wherein R is a C₁₄ to C₂₂ alkyl group and n is the average number of moles of addition of an ethylene oxide group and is 20 to 60.

In a preferred embodiment of the present invention, the lithographic printing plate surface protective agent incorporates a compound in which n in general formula (I) is 30 to 50 and more preferably is 30 to 40. In another preferred embodiment of the present invention, the lithographic printing plate surface protective agent incorporates a compound in which R in general formula (I) is a C₁₆ or C₁₈ alkyl group.

The lithographic printing plate surface protective agent of the present invention can be used in lithographic printing plate platemaking processes that start from various types of photosensitive lithographic printing plate precursors: platemaking can be carried out by treatment with the lithographic printing plate surface protective agent of the present invention after the photosensitive lithographic printing plate precursor has been subjected to imagewise photoexposure and development. An example of a preferred embodiment of use of the lithographic printing plate surface protective agent of the present invention is a platemaking method comprising subjecting a photosensitive lithographic printing plate precursor having a photopolymerizable photosensitive layer on a support, said photopolymerizable photosensitive layer containing a photopolymerization initiator and a compound having an ethylenically unsaturated bond, to imagewise photoexposure and development, and thereafter to treatment with the aforementioned lithographic printing plate surface protective agent.

### Effect of the Invention

The plate surface protective agent of the present invention not only protects the hydrophilicity of the non-image areas of a lithographic printing plate, but can also prevent the scumming caused by the attachment of fingerprints, oil, dirt, and so forth during image correction (e.g., additions to or corrective deletions from the image area), during storage in the time interval after platemaking up to printing or during storage until re-use, during installation in the press, and during handling. It also provides a thorough protection of the plate surface from scratching and so forth. The plate surface protective agent of the present invention is particularly useful for preventing fingerprint scumming, and, even when a fingerprint has been applied to the plate, can provide a high-quality impression with little paper loss after the start of printing.

In particular, fingerprints contain free fatty acids, glycerides, waxes, and so forth, and the alkyl chain length in the fatty acids is long and has a broad distribution. For this reason, a polyethylene oxide long-chain alkyl ether, which contains long-chain alkyl from the standpoint of affinity and which is easily removed by, for example, the dampening solution during printing, is desirable for remediating fingerprint scumming.

### Best Mode for Carrying Out the Invention

The lithographic printing plate surface protective agent of the present invention can be formulated as a solution type or as an emulsion type. Plate surface protective agents are typically first formulated in a concentrated form. This concentrate is then suitably diluted with water at the time of use to give the plate surface protective agent that is actually used. The contents of the individual components of the plate surface protective agent that are described hereinbelow are based on the total weight of the plate surface protective agent at the time of use.

The plate surface protective agent of the present invention characteristically contains at least one compound represented by general formula (I), below.

R-O-(CH₂CH₂O)ₙ-H (I)

(In the formula, R is a C₁₄ to C₂₂ alkyl group and n is the average number of moles of addition of the ethylene oxide group and is 20 to 60.)

The C₁₄ to C₂₂ alkyl group represented by R in the formula may be straight chain or branched chain.

When the alkyl group R is in the C₁₄ to C₂₂ range, this provides an excellent capacity to prevent fingerprint scumming and also an excellent solubility in the plate surface protective agent concentrate and an excellent antifoaming behavior by the plate surface protective agent. The most preferred range for R is C₁₆ to C₁₈ alkyl group, and in particular R is a C₁₆ or C₁₈ alkyl group. The capacity to prevent fingerprint scumming is weak when R is less than 14; when R is larger than 22, the capacity to prevent fingerprint scumming deteriorates and the solubility in the plate surface protective agent deteriorates.

Combinations of two or more compounds having different groups R may be used in the plate surface protective agent of the present invention.

An excellent capacity to prevent fingerprint scumming and an excellent solubility and antifoam behavior are obtained when n in the formula is in the range from 20 to 60. A more preferred range for n is 30 to 50 and the most preferred range is 30 to 40. The solubility in the plate surface protective agent deteriorates when n is less than 20, while the problem of easy foaming occurs at greater than 60. Combinations of two or more compounds having different values for n may be used in the plate surface protective agent of the present invention.

The content of the compound with general formula (I) in the plate surface protective agent of the present invention is suitably 0.1 to 3 % by weight. A content in this range provides an excellent capacity to prevent fingerprint scumming and enables the maintenance of a well-dissolved state in the plate surface protective agent without precipitation. 0.5 to 1.5 % by weight is more preferred, while 0.7 to 1.1 % by weight is most preferred.

These compounds can generally be commercially acquired, and the commercial products can be used by the present invention. The commercial products are specifically exemplified by the following: the Pionin series from Takemoto Oil & Fat Co., Ltd., the Emulgen series from Kao Corporation, and the Emalex series from Nihon Emulsion Co., Ltd.

Their structure can be determined using a nuclear magnetic resonance spectrometer or a liquid chromatograph with a mass analyzer detector (liquid chromatography conditions: reverse-phase column, mixed eluent of methanolic ammonium acetate solution and aqueous ammonium acetate solution; mass analyzer conditions: ionization method (electrospray ionization, cation detection)). As a methodology for detecting the average number of moles of addition in the ethylene oxide skeleton in the compound with general formula (I), and taking the case of a straight-chain alkyl group as an example, n can be determined using the formula n = (B/4)/(A/3) where, using a proton nuclear magnetic resonance spectrometer, A is the area of the peak due to the protons of the terminal methyl in R (3H) and B is the area of the peak assigned to the ethylene oxide protons (4H).

In addition to the compound described above, the plate surface protective agent of the present invention may additionally contain, for example, a water-soluble polymer compound, an inorganic acid and/or an organic acid and/or a salt of the preceding, surfactant other than the compound described above, organic solvent, a nitrate salt, a sulfate salt, a chelating agent, a preservative, and a defoamer. These components are individually described in the following.

In order to retain the hydrophilicity and protect the plate surface from scratching, a water-soluble polymer compound having a coating-forming capacity is preferably added to the plate surface protective agent. Such water-soluble polymer compounds can be exemplified by gum arabic, cellulose derivatives (for example, carboxymethyl cellulose, carboxyethyl cellulose, methyl cellulose, hydroxypropyl cellulose, methylpropyl cellulose, and so forth) and their modifications, polyvinyl alcohol and its derivatives, polyvinylpyrrolidone, polyacrylamide and its copolymers, vinyl methyl ether/maleic anhydride copolymer, vinyl acetate/maleic anhydride copolymer, styrene/ maleic anhydride copolymer, water-soluble soy polysaccharides, starch derivatives (e.g., dextrin, enzymatically degraded dextrin, hydroxypropylated starch, carboxymethylated starch, phosphate esterified starch, cyclodextrin), pullulan and pullulan derivatives, hemicellulose extracted from soybean, and so forth. Preferred thereamong for use are gum arabic, the starch derivative such as dextrin, carboxymethyl cellulose, soy polysaccharides and the like.

The content of the water-soluble polymer compound is preferably 0.1 to 25.0 % by weight and more preferably is 0.3 to 20.0 % by weight, in each case based on the total weight of the plate surface protective agent.

It is advantageous to use the plate surface protective agent generally in the acidic region of pH 2 to 6. In order to achieve such a pH, an adjustment is generally carried out by adding a mineral acid, organic acid, or salt of the preceding to the plate surface protective agent. This pH adjuster can be exemplified by nitric acid, sulfuric acid, phosphoric acid, metaphosphoric acid, polyphosphoric acid, and so forth within the realm of mineral acids. The organic acids can be exemplified by acetic acid, oxalic acid, citric acid, malic acid, malonic acid, tartaric acid, p-toluenesulfonic acid, lactic acid, levulinic acid, phytic acid, organophosphonic acids, and so forth. Salts preferred for use are, for example, disodium hydrogen phosphate, dipotassium hydrogen phosphate, diammonium hydrogen phosphate, sodium dihydrogen phosphate, potassium dihydrogen phosphate, ammonium dihydrogen phosphate, potassium pyrophosphate, sodium hexametaphosphate, sodium tripolyphosphate, sodium nitrate, potassium nitrate, ammonium nitrate, sodium sulfate, and so forth. A single selection from the mineral acids, organic acids, or their salts may be used, or two or more selections may be used in combination. The pH adjuster is added generally at about 0.01 to 3.0 % by weight based on the total weight of the plate surface protective agent.

Additional surfactant may also be present in the plate surface protective agent, for example, an anionic surfactant and/or a nonionic surfactant. The anionic surfactant can be exemplified by fatty acid salts, abietic acid salts, hydroxyalkanesulfonic acid salts, alkanesulfonic acid salts, dialkyl sulfosuccinate salts, alkyldiphenyl ether mono⁻ or disulfonate salts, straight-chain alkylbenzenesulfonate salts, branched alkylbenzenesulfonate salts, alkylnaphthalenesulfonate salts, alkylphenoxypolyoxyethylenepropylsulfonate salts, polyoxyethylene alkylsulfophenyl ether salts, sodium N-methyl-N-oleyltaurate, the disodium salt of N-alkylsulfosuccinic acid monoamide, salts of petroleum sulfonic acids, sulfated castor oil, sulfated beef tallow oil, the salts of sulfate esters of the alkyl esters of fatty acids, the salts of alkyl sulfate esters, the salts of sulfate esters of polyoxyethylene alkyl ethers, the salts of sulfate esters of fatty acid monoglycerides, the salts of sulfate esters of polyoxyethylene alkylphenyl ethers, the salts of sulfate esters of polyoxyethylene styrylphenyl ethers, the salts of alkyl phosphate esters, the salts of polyoxyethylene alkyl ether phosphate esters, the salts of polyoxyethylene alkylphenyl ether phosphate esters, partially saponified styrene-maleic anhydride copolymers, partially saponified olefin-maleic anhydride copolymers, the formaldehyde condensates of naphthalenesulfonates, and so forth. Particularly preferred for use thereamong are the dialkyl sulfosuccinate salts, the salts of alkyl sulfate esters, the salts of alkylnaphthalenesulfonates, and alkyldiphenyl ether mono- or disulfonate salts.

The nonionic surfactant can be exemplified by polyoxyethylene alkyl ethers, polyoxyethylene alkylphenyl ethers, glycerol/fatty acid partial esters, sorbitan/fatty acid partial esters, pentaerythritol/fatty acid partial esters, propylene glycol/fatty acid monoesters, sucrose/fatty acid partial esters, polyoxyethylene sorbitan/fatty acid partial esters, polyoxyethylene castor oil ethers, polyoxyethylene sorbitol/fatty acid partial esters, polyethylene glycol/fatty acid esters, polyglycerol/fatty acid partial esters, polyoxyethylene glycerol/fatty acid partial esters, fatty acid diethanolamides, N,N-bis-2-hydroxyalkylamines, polyoxyethylenealkylamines, triethanolamine/fatty acid esters, trialkylamine oxides, and so forth. Preferred for use thereamong are polyoxyethylene alkyl ethers, polyoxyethylene-polyoxypropylene block copolymers, and polyoxyethylene castor oil ethers.

Anionic and nonionic surfactants such as the oxyethylene adducts of acetylene glycols and acetylene alcohols, fluorinated types, silicones, and so forth can also be similarly used.

Two or more of these surfactants can also be used in combination. For example, the use is preferred of combinations of two or more anionic surfactants that differ from each and combinations of anionic surfactant with nonionic surfactant. These compounds are preferably selected for use as appropriate in view of their effects on the environment.

The surfactant content need not be particularly limited, but is preferably 0.01 to 20 % by weight of the plate surface protective agent.

An organic solvent with a boiling point of at least 130°C may be added to the plate surface protective agent in order to protect the oleosensitivity of the image areas. This type of organic solvent functions to remove the trace amounts of residual photosensitive film attached on the hydrophilic layer in non-images area and thereby raise the hydrophilicity of the non-image areas. With regard to specific examples of organic solvents with a boiling point of at least 130°C that may be used, among the alcohols there are n-hexanol, 2-ethylbutanol, n-heptanol, 2-heptanol, 3-heptanol, 2-octanol, 2-ethylhexanol, 3,5,5-trimethylhexanol, nonanol, n-decanol, undecanol, n-dodecanol, trimethylnonyl alcohol, tetradecanol, cyclohexanol, benzyl alcohol, tetrahydrofurfuryl alcohol, and so forth. Among the ketones there are methyl n-amyl ketone, methyl n-hexyl ketone, ethyl n-butyl ketone, di-n-propyl ketone, diacetone alcohol, cyclohexanone, and so forth. Among the esters there are n-amyl acetate; isoamyl acetate; methylisoamyl acetate; methoxybutyl acetate; benzyl acetate; ethyl lactate; butyl lactate; n-amyl lactate; benzoate esters such as methyl benzoate, ethyl benzoate, benzyl benzoate, and so forth; phthalate diesters such as dimethyl phthalate, diethyl phthalate, dibutyl phthalate, di-2-ethylhexyl phthalate, dioctyl phthalate, dinonyl phthalate, didecyl phthalate, dilauryl phthalate, butyl benzyl phthalate, and so forth; the esters of dibasic fatty acids, e.g., dioctyl adipate, butyl glycol adipate, dioctyl azelate, dibutyl sebacate, di(2-ethylhexyl) sebacate, dioctyl sebacate, and so forth; epoxidized triglycerides, for example, epoxidized soy oil and so forth; and phosphate esters such as tricresyl phosphate, trioctyl phosphate, trischloroethyl phosphate, and so forth.

Among polyhydric alcohols and derivatives thereof there are ethylene glycol, ethylene glycol monomethyl ether acetate, ethylene glycol monoethyl ether acetate, ethylene glycol butyl ether, ethylene glycol dibutyl ether, ethylene glycol isoamyl ether, ethylene glycol monophenyl ether, ethylene glycol monophenyl ether acetate, ethylene glycol benzyl ether, ethylene glycol monohexyl ether, methoxyethanol, diethylene glycol, diethylene glycol monomethyl ether, diethylene glycol monoethyl ether, diethylene glycol monobutyl ether, diethylene glycol monobutyl ether acetate, diethylene glycol dimethyl ether, diethylene glycol diethyl ether, diethylene glycol dibutyl ether, triethylene glycol, triethylene glycol monomethyl ether, triethylene glycol monoethyl ether, tetraethylene glycol, propylene glycol, dipropylene glycol, propylene glycol monoethyl ether, propylene glycol monobutyl ether, 1-butoxyethoxypropanol, dipropylene glycol, dipropylene glycol monomethyl ether, dipropylene glycol monoethyl ether, tripropylene glycol monomethyl ether, tripropylene glycol monobutyl ether, butylene glycol, hexylene glycol, octylene glycol, glycerol, diglycerol, trimethylolpropane, glycerol monoacetate, glycerol triacetates, and so forth.

As hydrocarbons there are petroleum fraction-derived aromatic and aliphatic compounds with a boiling point of at least 160°C, squalane, and so forth.

The criteria for selection of the organic solvent are, for example, environmental safety and particularly odor. A single one of these solvents may be used or two or more may be used in combination. The amount of solvent use is preferably 0.1 to 5.0 % by weight in the plate surface protective agent and more preferably is 0.3 to 3.0 % by weight.

The organic solvent may take a solution form in the plate surface protective agent by solubilization by the surfactant or may take an emulsion form by emulsification and dispersion as the oil phase.

The nitrate salt or sulfate salt that can be incorporated in the plate surface protective agent can be exemplified by magnesium nitrate, sodium nitrate, potassium nitrate, ammonium nitrate, sodium sulfate, potassium sulfate, ammonium sulfate, sodium bisulfate, nickel sulfate, and so forth. The use quantity thereof is 0.05 to 1.0 % by weight in the plate surface protective agent.

A hydrophilic vinyl copolymer, such as a copolymer of vinylpyrrolidone and vinyl acetate, may be incorporated in the plate surface protective agent so as to promote adhesion with the backcoat surface of the plate.

The plate surface protective agent is typically sold as a concentrate and is diluted for use at the time of use by the addition of tap water, well water, and so forth. Since, inter alia, the calcium ion that may be present in the tap water or well water used for dilution has a negative influence on printing and is a cause of facile scumming of the printed matter, this problem can be solved by the addition of a chelating compound. Preferred chelating compounds can be exemplified by polyphosphates such as Na₂P₂O₇, Na₅P₃O₃, Na₃P₃O₉, Na₂O₄P(NaO₃P)PO₃Na₂, sodium polymetaphosphate, Calgon (trade name) and so forth; aminopolycarboxylic acids such as ethylenediaminetetraacetic acid and its potassium and sodium salts, dihydroxyethylglycine and its potassium and sodium salts, hydroxyiminodiacetic acid and its potassium and sodium salts, glycol ether diaminetetraacetic acid and its potassium and sodium salts, diethylenetriaminepentaacetic acid and its potassium and sodium salts, triethylenetetraminehexaacetic acid and its potassium and sodium salts, hydroxyethylethylenediaminetriacetic acid and its potassium and sodium salts, 1,2-diaminocyclohexanetetraacetic acid and its potassium and sodium salts, 1,3-diamino-2-propanoltetraacetic acid and its potassium and sodium salts, and so forth; nitrilotriacetic acid and its potassium and sodium salts; organophosphonic acids such as 1-hydroxyethane-1,1-diphosphonic acid and its potassium and sodium salts, aminotri(methylenephosphonic acid) and its potassium and sodium salts, ethylenediaminetetra(methylenephosphonic acid) and its potassium and sodium salts, diethylenetriaminepenta(methylenephosphonic acid) and its potassium and sodium salts, hexamethylenediaminetetra(methylenephosphonic acid) and its potassium and sodium salts, and so forth; and phosphonoalkanetricarboxylic acids such as 2-phosphonobutane-1,2,4-tricarboxylic acid and its potassium and sodium salts, 2-phosphonobutane-2,3,4-tricarboxylic acid and its potassium and sodium salts, and 1-phosphonoethane-1,2,2-tricarboxylic acid and its potassium and sodium salts. The salts with organic amines are also effective in place of the sodium and potassium salts of these chelating agents. A chelating agent is selected that is stable in the plate surface protective agent composition and that does not impair the printing properties. The amount of addition of chelating agent is suitably 0.001 to 1.0 % by weight with reference to the plate surface protective agent at the time of use.

A preservative, defoamer, and so forth can be added to the plate surface protective agent. The preservative can be exemplified by phenol and its derivatives; formalin; imidazole derivatives; sodium dehydroacetate; 4-isothiazolin-3-one derivatives; 5-chloro-2-methyl-3-isothiazolone; 2-methyl-3-isothiazolone; benzoisothiazolin-3-one; benzotriazole derivatives; amidinoguanidine derivatives; quaternary ammonium salts; pyridine, quinoline, and guanidine derivatives; diazine and triazole derivatives; oxazole and oxazine derivatives; nitrobromo alcohol types such as 2-bromo-2-nitropropane-1,3-diol, 1,1-dibromo-1-nitro-2-ethanol, and 1,1-dibromo-1-nitro-2-propanol omadine; and so forth. The preferred quantity of addition for the preservative is a quantity that exhibits a stable effect against bacteria, mold, yeast, and so forth, and, while this will also vary with the species of bacteria, mold, and yeast, the range of 0.01 to 4.0 % by weight in the plate surface protective agent is preferred. Two or more preservatives are preferably used in combination so as to demonstrate efficacy against various mold and bacteria.

The defoamer can be a general silicone system self-emulsifying type or emulsified type or a surfactant nonionic compound with an HLB not greater than 5. Silicone defoamers, for example, dimethylsilicones and so forth, are preferred. Emulsified/dispersed types or solubilized types can be used thereamong. The preferred optimal range is 0.001 to 1.0 % by weight in the plate surface protective agent.

The component that balances out the plate surface protective agent of the present invention is water. It is advantageous in terms of transport for the plate surface protective agent to be prepared as a concentrate that contains less water than at the time of use and then to dilute with water at the time of use. The degree of concentration in this instance is desirably such that the individual components do not separate or precipitate. The plate surface protective agent may be formulated as an emulsified/dispersed type with an organic solvent being used as its oil phase, or may be formulated as a solubilized type relying on the aid of a solubilizing agent. Another preferred embodiment is a solidified plate surface protective agent as yielded by removal of the water fraction by, for example, spray drying or as yielded by mixing solid ingredients.

When the plate surface protective agent is implemented as an emulsified type, emulsification and dispersion can be effected, for example, by adjusting the aqueous phase to a temperature of 40°C ± 5°C and gradually dripping the prepared oil phase into the aqueous phase while subjecting the aqueous phase to high-speed stirring; then, after thorough stirring, passage through a pressure-type homogenizer yields the emulsion.

The conditions for using the plate surface protective agent are not particularly limited; however, the use of, for example, an automatic gum coater is preferred since this enables uniform coating. Treatment with the plate surface protective agent can be carried out immediately after the development step without a water wash or can be carried out after development (including a water wash step, a water wash with a circulating water stream, or a water wash with scant application) or after treatment with a surfactant-containing rinse solution.

Treatment with the plate surface protective agent is also suitably carried out using an automatic developer. An automatic developer typically has a developing section and a post-treatment section and includes a device that transports the lithographic printing plate precursor, various tanks for the process solutions, and a spray device; it carries out development and post-treatment, while the photoexposed lithographic printing plate precursor is being horizontally transported, using pumps to pump up the various process solutions and spray them through spray nozzles. In another known method, development is carried out, using, for example, guide rolls, by transport immersed in a solution in a process solution tank filled with process solution. In another known method, a post-development water rinse is carried out by feeding a small, constant amount of rinse water onto the plate surface and re-using the effluent water therefrom as water for diluting the developer stock solution.

With automatic development as described in the preceding, processing can be carried out while replenishing the individual process solutions with make-up solutions in correspondence to the amount of processing, the operating time, and so forth. In addition, a process configuration can also be used in which processing is carried out with essentially unused process solution, so-called single-use processing.

The lithographic printing plate carrying a plate surface protective layer yielded by treatment with the above-described plate surface protective agent is mounted in an offset printing press and used for printing a plurality of sheets.

There are no particular limitations on the lithographic printing plate precursor (photosensitive lithographic printing plate) that can make use of the plate surface protective agent of the present invention, and the plate surface protective agent of the present invention can be applied to the heretofore used conventional positive-acting and negative-acting photosensitive lithographic printing plates, negative-acting and positive-acting infrared photosensitive lithographic printing plates, and photopolymerizable photosensitive lithographic printing plates. Here, the conventional photosensitive lithographic printing plate refers to a printing plate of the type where imagewise photoexposure is carried out through an original film.

The plate surface protective agent of the present invention can preferably be applied to photopolymerizable photosensitive lithographic printing plates. The type of photopolymerizable photosensitive lithographic printing plate is not particularly limited, and the plate surface protective agent of the present invention can be applied to, for example, infrared photopolymerizable photosensitive lithographic printing plates (including heat mode negative-acting printing plates (so-called thermal polymerizable photosensitive lithographic printing plates), which contain a compound that is polymerized by the radicals generated by the heat produced when absorbed infrared radiation is converted to heated), ultraviolet photopolymerizable photosensitive lithographic printing plates, and so forth. Photopolymerizable photosensitive lithographic printing plates have a photopolymerizable photosensitive layer, generally comprising a photopolymerization initiator (also referred to herebelow as a radical generator) and an ethylenically unsaturated bond-containing compound (also referred to herebelow as a radically polymerizable compound), disposed on a support.

Examples of the structure of various types of photosensitive lithographic printing plates are described in the following.

### [Conventional photosensitive lithographic printing plates]

The positive-acting photosensitive lithographic printing plates generally comprise a suitable support, e.g., metal or plastic, coated with an o-quinonediazide compound, either alone or mixed with a base-soluble resin such as a novolac-type phenolic resin, cresol resin, and so forth. When exposed to actinic light through a transparent positive image, the o-quinonediazide compound in the exposed area is decomposed and becomes alkali-soluble and is then easily removed by an aqueous alkaline solution to give a positive image.

The negative-acting photosensitive composition, on the other hand, frequently uses a diazonium salt or azide compound or a photopolymerizable compound; this photosensitive material is coated, either alone or mixed with suitable additives such as a resin, on a support to give a negative-acting photosensitive lithographic printing plate.

These photosensitive lithographic printing plates (also referred to as PS plates herebelow) encompass, for example, negative-acting PS plates such as an aluminum plate coated with a photosensitive layer comprising a mixture of a diazo resin (the salt of a condensation product between p-diazodiphenylamine and paraformaldehyde) and shellac, as described in British Patent 1,350,521, or an aluminum plate coated with a photosensitive layer comprising a mixture of a diazo resin with a polymer having the hydroxyethyl methacrylate unit or hydroxyethyl acrylate unit as its main repeat unit, as described in British Patents 1,460,978 and 1,505,739, as well as positive-acting PS plates such as an aluminum plate coated with a photosensitive layer comprising a mixture of a photosensitive o-quinonediazide material and a novolac-type phenolic resin, as described in Japanese Patent Application Publication No. S50-125806A. Other preferred PS plates are PS plates comprising an aluminum plate coated with a photosensitive layer of photocrosslinkable photopolymer, as specifically shown in United States Patent No. 3,860,426; PS plates comprising an aluminum plate coated with a photosensitive layer of a photopolymerizable photopolymer composition as described in United States Patent Nos. 4,072,528 and 4,072,527; and PS plates comprising an aluminum plate coated with a photosensitive layer comprising a mixture of an azide and a water-soluble polymer, as described in British Patent Nos. 1,235,281 and 1,495,861. Particularly preferred PS plates among the preceding PS plates are positive-acting PS plates having a photosensitive layer comprising an o-naphthoquinone diazide compound and a novolac resin, as particularly described in United States Patent No. 4,259,434, second line from the bottom of column 3 to line 14, column 6.

### [Infrared photosensitive lithographic printing plates]

Infrared photosensitive lithographic printing plates have an image-forming layer on a support along with other optional layers. The positive-acting image-forming layer contains (A) an infrared-absorbing dye and also contains (B) an alkali-soluble polymer compound and may optionally contain (C) a compound that is compatible with the alkali-soluble polymer compound, that reduces the solubility of this alkali-soluble polymer compound in aqueous alkaline solutions, and that undergoes a decline in its solubility-suppressing function when heated, and (D) a cyclic acid anhydride. In the case of the negative-acting lithographic printing plate precursor, in order to form the image area by curing of the photoexposed area, the image-forming layer additionally contains (E) a compound that generates acid when heated and (F) a crosslinking agent that crosslinks under the action of acid. Each of these constituent components will be briefly described in the following.

### - (A) The infrared-absorbing dye -

The infrared-absorbing dye used in the image-forming layer is a dye that absorbs infrared light and thereupon generates heat, but is not otherwise particularly limited. The various dyes known as infrared-absorbing dyes can be used.

The infrared-absorbing dyes can be exemplified by commercially available dyes and by the dyes known in the literature (for example, "Dye Handbook", edited by The Society of Synthetic Organic Chemistry, Japan, 1970), for example, azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts, metal thiolate complexes, and so forth. Among these dyes, those that absorb infrared light or near infrared light are particularly preferred from the standpoint of suitability for utilization with a laser that generates infrared light or near infrared light.

Preferred examples of such dyes that absorb infrared light or near infrared light are the cyanine dyes described in Japanese Patent Application Publication Nos. S58-125246A, 59-84356A, 59-202829A, 60-78787A and so forth; the methine dyes described in Japanese Patent Application Publication Nos. S58-173696A, 58-181690A, 58-194595A and so forth; the naphthoquinone dyes described in Japanese Patent Application Publication Nos. S58-112793A, 58-224793A, 59-48187A, 59-73996A, 60-52940A, 60-63744A and so forth; the squarylium dyes described in Japanese Patent Application Publication No. S58-112792A and so forth; the cyanine dyes described in British Patent 434,875; and the dihydroperimidine squarylium dyes described in United States Patent No. 5,380,635.

Other preferred dyes are the near infrared absorbers/sensitizers described in United States Patent No. 5,156,938; the substituted arylbenzo(thio)pyrylium salts described in United States Patent No. 3,881,924; the trimethine thiapyrylium salts described in Japanese Patent Application Publication No. S57-142645A (United States Patent No. 4,327,169); the pyrylium compounds described in Japanese Patent Application Publication Nos. S58-181051A, 58-220143A, 59-41363A, 59-84248A, 59-84249A, 59-146063A, and 59-146061A; the cyanine dyes described in Japanese Patent Application Publication No. S59-216146A; the pentamethine thiopyrylium salts described in U.S. Patent No. 4,283,475; and the pyrylium compounds described in Japanese Patent Publication Nos. H5-13514 and 5-19702; while preferred commercial products are Epolight III-178, Epolight III-130, Epolight III-125, and Epolight IV-62A (Epolin, Inc).

Other preferred examples are the near infrared-absorbing dyes represented by formulas (I) and (II) in United States Patent No. 4,756,993.

More preferred among the preceding are cyanine dyes, squarylium dyes, pyrylium salts, and nickel thiolate complexes.

Compounds represented by general formula (Z) below can be provided as additional specific examples.

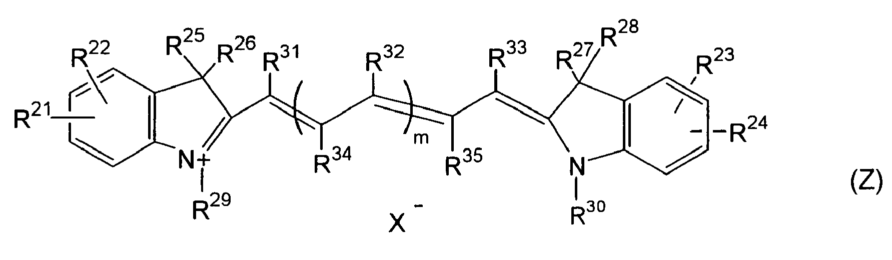

In general formula (Z), R²¹ to R²⁴ each independently represent the hydrogen atom or possibly substituted C₁ to C₁₂ alkyl group, alkenyl group, alkoxy group, cycloalkyl group, or aryl group, wherein R²¹ and R²² may be bonded to form a cyclic structure and R²³ and R²⁴ may be bonded to form a cyclic structure.

R²¹ to R²⁴ are exemplified by the hydrogen atom, methyl group, ethyl group, phenyl group, dodecyl group, naphthyl group, vinyl group, allyl group, and cyclohexyl group, wherein these groups may additionally carry substituents. Examples of these substituents are halogen atoms, carbonyl group, the nitro group, the nitrile group, the sulfonyl group, the carboxyl group, carboxylic acid esters, sulfonic acid esters and the like.

R²⁵ to R³⁰ in the formula each independently represent possibly substituted C₁ to C₁₂ alkyl group. R²⁵ to R³⁰ are exemplified by methyl group, ethyl group, phenyl group, dodecyl group, naphthyl group, vinyl group, allyl group, and cyclohexyl group, wherein these groups may additionally carry substituents. Examples of these substituents are halogen atoms, carbonyl group, the nitro group, the nitrile group, the sulfonyl group, the carboxyl group, carboxylic acid esters, sulfonic acid esters and the like.

R³¹ to R³³ in the formula each independently represent the hydrogen atom, a halogen atom, or possibly substituted C₁ to C₈ alkyl group, wherein R³² may be bonded to R³¹ or R³³ to form a cyclic structure and when m > 2 a plurality of R³² may be bonded to each other to form a cyclic structure.

This R³¹ to R³³ is exemplified by the chlorine atom, cyclohexyl group, and the cyclopentyl ring and cyclohexyl ring as yielded by bonding between R^{32'}s, wherein these groups may additionally carry substituents. These substituents are exemplified by halogen atoms, carbonyl group, the nitro group, the nitrile group, the sulfonyl group, the carboxyl group, carboxylic acid esters, sulfonic acid esters and the like.

m represents an integer from 1 to 8 and is preferably 1 to 3.

R³⁴ and R³⁵ in the formula each independently represent the hydrogen atom, a halogen atom, or possibly substituted C₁ to C₈ alkyl group, wherein R³⁴ may be bonded to R³⁵ to form a cyclic structure and when m > 2 a plurality of R³⁴ may be bonded to each other to form a cyclic structure.

R³⁴ and R³⁵ are each exemplified by the chlorine atom, cyclohexyl group, and the cyclopentyl ring and cyclohexyl ring as yielded by bonding between R^{34'}s, wherein these groups may additionally carry substituents. These substituents are exemplified by halogen atoms, carbonyl group, the nitro group, the nitrile group, the sulfonyl group, the carboxyl group, carboxylic acid esters, sulfonic acid esters and the like.

m represents an integer from 1 to 8 and is preferably 1 to 3.

X in the formula represents an anion, for example, perchloric acid, tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid, para-toluenesulfonic acid and so forth.

The following are preferred among the preceding: hexafluorophosphoric acid and alkyl aromatic sulfonic acids such as triisopropylnaphthalenesulfonic acid and 2,5-dimethylbenzenesulfonic acid.

Among the compounds represented by the preceding general formula (Z), the use of the specific compounds shown below is preferred, but the present invention is not limited thereto.

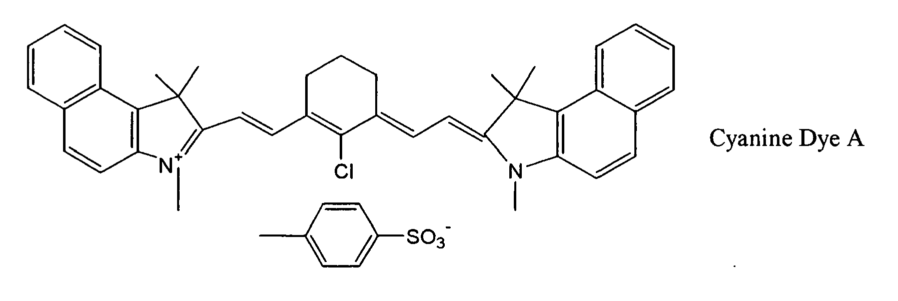

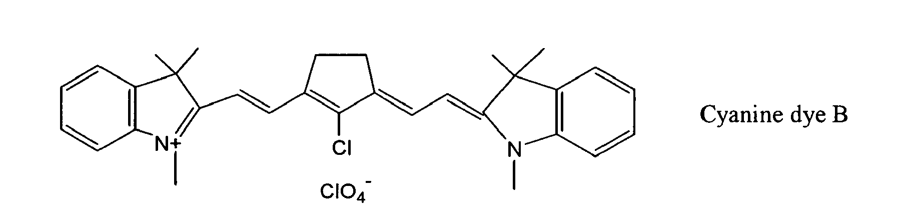

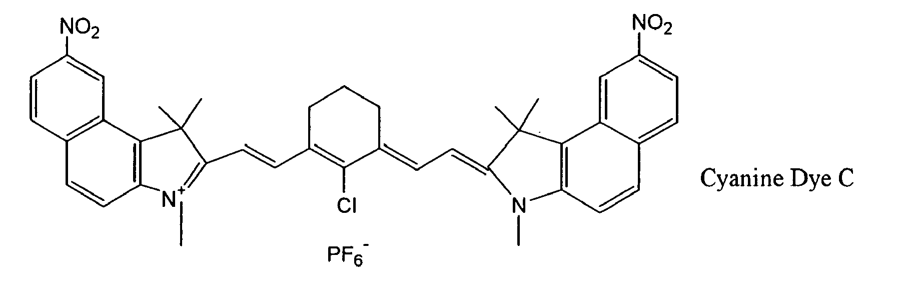

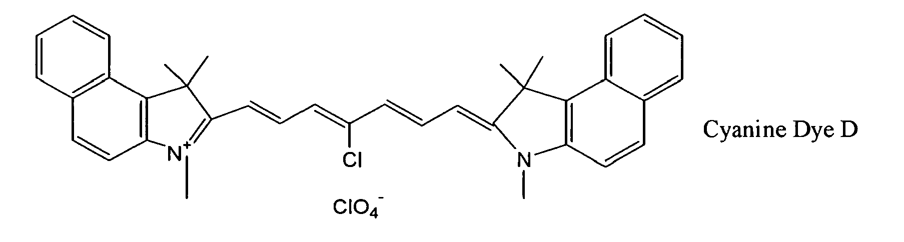

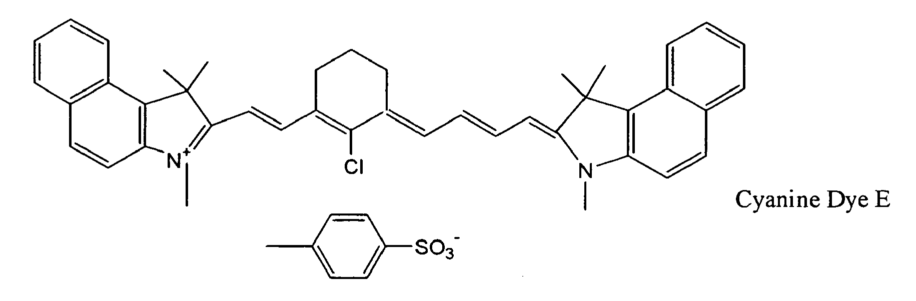

The content of the above-cited infrared-absorbing dye, expressed in each instance with reference to the weight of the total solids fraction in the image-forming layer, is preferably 0.01 to 50 % by weight, more preferably 0.1 to 10 % by weight, and most preferably 0.5 to 10 % by weight.

A low sensitivity can occur when this content is less than 0.01 % by weight, while more than 50 % by weight can result in a reduction in the uniformity of the image-forming layer and a deterioration in its durability.

### - (B) The alkali-soluble polymer compound -

Aqueous alkali-soluble polymer compounds that have an acidic group (1) to (3), infra, in their main chain structure and/or side chain structure can be used as the alkali-soluble polymer compound (also referred to below as component (B)).
(1) the phenol group (-Ar-OH)
(2) the sulfonamide group (-SO₂NH-R)
(3) the substituted sulfonamide-type acid group (referred to in the following as an active imide group) (-SO₂NHCOR, -SO₂NHSO₂R, -CONHSO₂R)

Ar in the preceding (1) to (3) represents a possibly substituted divalent aryl linking group, while R represents possibly substituted hydrocarbon radical.

Specific examples of these are provided in the following, but the present invention is not limited thereto.
(1) The phenol-functional alkali-soluble polymer compounds can be exemplified by novolac resins, e.g., condensation polymers from phenol and formaldehyde, condensation polymers from m-cresol and formaldehyde, condensation polymers from p-cresol and formaldehyde, condensation polymers from m-/p-cresol mixtures and formaldehyde, and condensation polymers from phenol, cresol (m-cresol or p-cresol or a m-/p-cresol mixture), and formaldehyde, and can also be exemplified by condensation polymers from pyrogallol and acetone. Other examples are polymer compounds yielded by the polymerization of monomer having the phenol group in side chain position.
   Polymer compounds having phenolic hydroxyl group in side chain position can be exemplified by polymer compounds yielded by the homopolymerization of polymerizable monomer comprising a low molecular weight compound that contains at least one phenolic hydroxyl group and at least one polymerizable unsaturated bond, or yielded by the copolymerization of such a polymerizable monomer with other polymerizable monomer.
   Monomer having the phenol group in side chain position can be exemplified by acrylamide, methacrylamide, acrylate esters, and methacrylate esters, in each case having the phenol group in side chain position, and by hydroxystyrene, and the like.
   Suitable specific examples are N-(2-hydroxyphenyl)acrylamide, N-(3-hydroxyphenyl)acrylamide, N-(4-hydroxyphenyl)acrylamide, N-(2-hydroxyphenyl)methacrylamide, N-(3-hydroxyphenyl)methacrylamide, N-(4-hydroxyphenyl)methacrylamide, o-hydroxyphenyl acrylate, m-hydroxyphenyl acrylate, p-hydroxyphenyl acrylate, o-hydroxyphenyl methacrylate, m-hydroxyphenyl methacrylate, p-hydroxyphenyl methacrylate, o-hydroxystyrene, m-hydroxystyrene, p-hydroxystyrene, 2-(2-hydroxyphenyl)ethyl acrylate, 2-(3-hydroxyphenyl)ethyl acrylate, 2-(4-hydroxyphenyl)ethyl acrylate, 2-(2-hydroxyphenyl)ethyl methacrylate, 2-(3-hydroxyphenyl)ethyl methacrylate, 2-(4-hydroxyphenyl)ethyl methacrylate, and so forth.
   Viewed from the perspective of the image formability, the subject phenol-functional alkali-soluble polymer compound preferably has a weight-average molecular weight of 5.0 × 10² to 2.0 × 10⁵ and a number-average molecular weight of 2.0 × 10² to 1.0 × 10⁵.
   A single phenol-functional alkali-soluble polymer compound may be used or two or more may be used in combination. When a combination is employed, a combination may be employed that includes a condensation polymer from formaldehyde and C₃ to C₈ alkyl-substituted phenol, such as a condensation polymer from t-butylphenol and formaldehyde or a condensation polymer from octylphenol and formaldehyde, as described in United States Patent No. 4,123,279.
   These condensation polymers also preferably have a weight-average molecular weight of 5.0 × 10² to 2.0 × 10⁵ and a number-average molecular weight of 2.0 × 10² to 1.0 × 10⁵.
(2) The sulfonamide group-containing alkali-soluble polymer compound can be exemplified by polymer whose major monomer constituent unit derives from a sulfonamide group-containing compound, i.e., a homopolymer or a copolymer as yielded by the copolymerization of such a monomer constituent unit with other polymerizable monomer.
   The sulfonamide group-containing polymerizable monomer may be a monomer comprising a low molecular weight compound that has, in each molecule, at least one polymerizable unsaturated bond and at least one sulfonamide group -SO₂-NH- in which at least one hydrogen atom is bonded on the nitrogen atom. More specifically, preferred low molecular weight compounds contain the acryloyl group, allyl group, or vinyloxy group and a substituted or monosubstituted aminosulfonyl group or a substituted sulfonylimino group.
   The compounds represented by general formulas (a) through (e) below are examples of the low molecular weight compounds under consideration, but the present invention is not limited thereto. 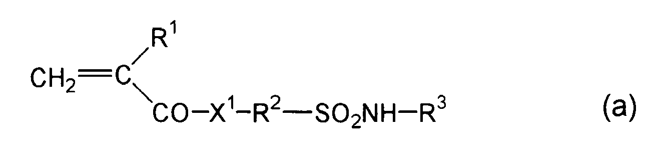 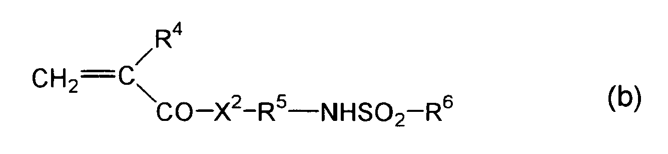 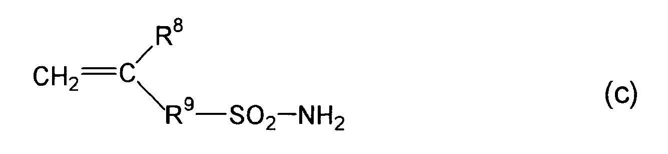 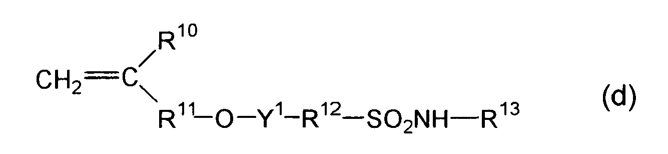 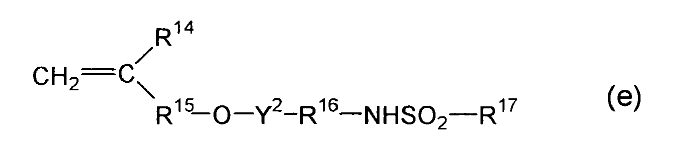 In the formulas, X¹ and X² each independently represent the oxygen atom or NR⁷. R¹ and R⁴ each independently represent the hydrogen atom or CH₃. R², R⁵, R⁹, R¹², and R¹⁶ each independently represent possibly substituted C₁ to C₁₂ alkylene group, cycloalkylene group, arylene group, or aralkylene group. R³, R⁷, and R¹³ each independently represent the hydrogen atom or possibly substituted C₁ to C₁₂ alkyl group, cycloalkyl group, aryl group, or aralkyl group. R⁶ and R¹⁷ each independently represent possibly substituted C₁ to C₁₂ alkyl group, cycloalkyl group, aryl group, or aralkyl group. R⁸, R¹⁰, and R¹⁴ each independently represent the hydrogen atom or CH₃. R¹¹ and R¹⁵ each independently represent a single bond or possibly substituted C₁ to C₁₂ alkylene group, cycloalkylene group, arylene group, or aralkylene group. Y¹ and Y² each independently represent a single bond or CO.
   Preferred for use among the preceding are m-aminosulfonylphenyl methacrylate, N-(p-aminosulfonylphenyl)methacrylamide, N-(p-aminosulfonylphenyl)acrylamide, and so forth.
(3) The active imide group-containing alkali-soluble polymer compound can be exemplified by polymer whose major monomer constituent unit derives from an active imide group-containing compound.

Polymer whose major monomer constituent unit derives from an active imide group-containing compound can be exemplified by a polymer compound as yielded by the homopolymerization of monomer comprising a low molecular weight compound that contains, in each molecule, at least one active imide group represented by the following formula and at least one polymerizable unsaturated bond, or as yielded by the copolymerization of such monomer with other polymerizable monomer.

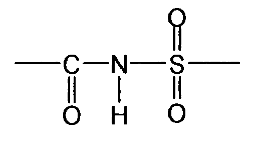

Preferred specific examples of such compounds are N-(p-toluenesulfonyl)methacrylamide, N-(p-toluenesulfonyl)acrylamide, and so forth.

Other preferred examples are polymer compounds as yielded by the polymerization of two or more selections from the above-described phenol group-containing polymerizable monomer, sulfonamide group-containing polymerizable monomer, and active imide group-containing polymerizable monomer, and polymer compounds as yielded by the copolymerization of two or more of the preceding polymerizable monomers with other polymerizable monomer.

The blending ratio (M1 : M2 and/or M3; weight ratio) in the case of the copolymerization of phenol group-containing polymerizable monomer (M1) with sulfonamide group-containing polymerizable monomer (M2) and/or active imide group-containing polymerizable monomer (M3) is preferably 50 : 50 to 5 : 95 and more preferably is 40 : 60 to 10 : 90.

When the alkali-soluble polymer compound is a copolymer constituted of a monomer constituent unit that contains a selection from any of the preceding acid groups (1) to (3) plus a constituent unit from another polymerizable monomer, the content in the copolymer of themonomer constituent unit that contains a selection from any of the preceding acid groups (1) to (3) is preferably at least 10 mol% and more preferably at least 20 mol%.

When the content of this monomer constituent unit is less than 10 mol%, an adequate alkali-solubility is not obtained and the development latitude is narrowed.

The heretofore known graft copolymerization methods, block copolymerization methods, and random polymerization methods can be used as the method of synthesizing the copolymer under consideration.

Copolymerization is carried out with polymerizable monomer whose constituent unit is monomer that contains a selection from any of the preceding acid groups (1) to (3). The other polymerizable monomer can be exemplified by the monomers given by the following (a) to (1), but the present invention is not limited thereto.
(a) Acrylate esters and methacrylate esters that have aliphatic hydroxyl, such as 2-hydroxyethyl acrylate, 2-hydroxyethyl methacrylate and the like.
(b) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, glycidyl acrylate, N-dimethylaminoethyl acrylate and the like.
(c) Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, glycidyl methacrylate, N-dimethylaminoethyl methacrylate and the like.
(d) Acrylamides and methacrylamides such as acrylamide, methacrylamide, N-methylolacrylamide, N-ethylacrylamide, N-hexylmethacrylamide, N-cyclohexylacrylamide, N-hydroxyethylacrylamide, N-phenylacrylamide, N-nitrophenylacrylamide, N-ethyl-N-phenylacrylamide and the like.
(e) Vinyl ethers such as ethyl vinyl ether, 2-chloroethyl vinyl ether, hydroxyethyl vinyl ether, propyl vinyl ether, butyl vinyl ether, octyl vinyl ether, phenyl vinyl ether and the like.
(f) Vinyl esters such as vinyl acetate, vinyl chloroacetate, vinyl butyrate, vinyl benzoate and the like.
(g) Styrenes such as styrene, α-methyl styrene, methyl styrene, chloromethyl styrene and the like.
(h) Vinyl ketones such as methyl vinyl ketone, ethyl vinyl ketone, propyl vinyl ketone, phenyl vinyl ketone and the like.
(i) Olefins such as ethylene, propylene, isobutylene, butadiene, isoprene and the like.
(j) N-vinylpyrrolidone, N-vinylcarbazole, 4-vinylpyridine, acrylonitrile, methacrylonitrile, and so forth.
(k) Unsaturated imides such as maleimide, N-acryloylacrylamide, N-acetylmethacrylamide, N-propionylmethacrylamide, N-(p-chlorobenzoyl)methacrylamide and the like.
(l) Unsaturated carboxylic acids such as acrylic acid, methacrylic acid, maleic anhydride, itaconic acid and the like.

From the perspective of film strength, the aqueous alkali-soluble polymer compound under consideration, regardless of whether it is a homopolymer or copolymer, preferably has a weight-average molecular weight of at least 2,000 and a number-average molecular weight of at least 500 and more preferably has a weight-average molecular weight of 5,000 to 300,000, a number-average molecular weight of 800 to 250,000, and a dispersity (weight-average molecular weight/number-average molecular weight) of 1.1 to 10.

In addition, when the alkali-soluble polymer compound under consideration is a phenol-formaldehyde resin, cresol-aldehyde resin, or the like, its weight-average molecular weight is preferably 500 to 20,000 and its number-average molecular weight is preferably 200 to 10,000.

The content of the aqueous alkali-soluble polymer compound under consideration, in each instance expressed with reference to the weight of the total solids fraction in the image-forming layer, is preferably 30 to 99 % by weight, more preferably 40 to 95 % by weight, and most preferably 50 to 90 % by weight.

The durability of the image-forming layer may be reduced when this content is less than 30 % by weight, while the sensitivity and durability may be reduced when this content exceeds 99 % by weight.

Only a single such polymer compound may be used, or two or more may be used in combination.

### - (C) The compound that is compatible with the aforementioned alkali-soluble polymer compound, which reduces the solubility of this alkali-soluble polymer compound in aqueous alkaline solutions, and that undergoes a decline in its solubility-suppressing function when heated -

This component (C) is a compound (i) that, through the activity of a hydrogen-bonding functional group present in the molecule, exhibits an excellent compatibility with the aforementioned alkali-soluble polymer compound (B) and thereby has the capacity to form a uniform coating solution for producing the image-forming layer and (ii) that, through its interaction with the alkali-soluble polymer compound, has the capacity to inhibit the alkali solubility of the alkali-soluble polymer compound (dissolution inhibiting activity).

This dissolution inhibiting action on the alkali-soluble polymer compound is extinguished by the application of heat; however, in those instances where this infrared absorber itself is a compound that is decomposed by heating, the dissolution inhibiting activity on the alkali-soluble polymer compound cannot be adequately reduced when sufficient energy for decomposition is not imparted by the conditions, e.g., laser output, exposure time, and so forth, and there is a risk of a decline in sensitivity. Due to this, the thermal decomposition temperature of component (C) is preferably at least 150°C.

Based on a consideration of the interaction with the aforementioned alkali-soluble polymer compound (B), an appropriate selection of component (C) can be made from among compounds capable of interacting with the alkali-soluble polymer compound, e.g., sulfone compounds, ammonium salts, phosphonium salts, amide compounds, and so forth.

The blending ratio (C/B) between component (C) and the above-described alkali-soluble polymer compound (B) is generally preferably 1/99 to 25/75.

The compound represented by general formula (Z) and described above as an infrared-absorbing dye (A) also exhibits a component (C) activity, and the activities of both component (A) and component (C) can be exhibited when using, for example, a cyanine dye as represented by general formula (Z).

### - (D) The cyclic acid anhydride -

A cyclic acid anhydride may additionally be used in the lithographic printing plate precursor. This cyclic acid anhydride has in its structure a bond that conjugates with the carbonyl group of the carboxylic acid anhydride, and its decomposition rate is restrained by the increased stability of this carbonyl group, resulting in the generation of acid by decomposition at a suitable rate during elapsed time in storage. This prevents the developability from deteriorating during elapsed time in storage and can maintain long-term stability for the developability.

This cyclic acid anhydride is exemplified by compounds represented by the following general formulas (III) and (IV).

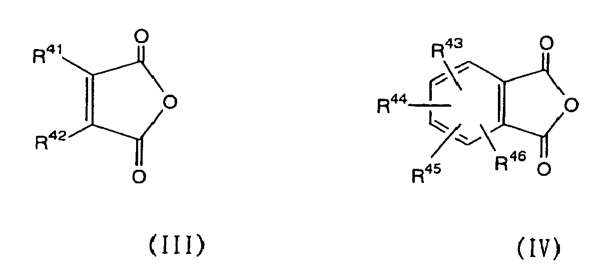

R⁴¹ and R⁴² in general formula (III) each independently represent the hydrogen atom or possibly substituted C₁ to C₁₂ alkyl group, alkenyl group, alkoxy group, cycloalkyl group, aryl group, carbonyl group, the carboxyl group, or a carboxylic acid ester. R⁴¹ and R⁴² may also be connected to each other to form a cyclic structure.

Suitable examples of R⁴¹ and R⁴² are the hydrogen atom and unsubstituted C₁ to C₁₂ alkyl group, aryl group, alkenyl group, and cycloalkyl group. Specific examples are the hydrogen atom, methyl group, ethyl group, phenyl group, dodecyl group, naphthyl group, vinyl group, allyl group, and cyclohexyl group wherein these groups may additionally carry substituents.

When R⁴¹ and R⁴² are connected to each other to form a cyclic structure, this cyclic group may be, for example, phenylene group, naphthylene group, the cyclohexene group, or the cyclopentene group.

The aforementioned substituents can be exemplified by halogen atoms, the hydroxyl group, carbonyl group, sulfonate ester, the nitro group, the nitrile group, and so forth.

R⁴³, R⁴⁴, R⁴⁵, and R⁴⁶ in general formula (IV) each independently represent the hydrogen atom, the hydroxyl group, a halogen atom such as chlorine, the nitro group, the nitrile group, or possibly substituted C₁ to C₁₂ alkyl group, alkenyl group, alkoxy group, cycloalkyl group, aryl group, carbonyl group, the carboxyl group, or a carboxylic acid ester group.

Preferred examples of R⁴³, R⁴⁴, R⁴⁵, and R⁴⁶ are the hydrogen atom, halogen atoms, unsubstituted C₁ to C₁₂ alkyl group, alkenyl group, and C₆ to C₁₂ aryl group. Specific examples are methyl, vinyl, phenyl, and allyl wherein these groups may additionally carry substituents.

These substituents can be, for example, a halogen atom, the hydroxyl group, carbonyl group, sulfonate ester, the nitro group, the nitrile group, and the carboxyl group.

Preferred examples of the cyclic acid anhydride are phthalic anhydride, 3,4,5,6-tetrahydrophthalic anhydride, tetrachlorophthalic anhydride, 3-hydroxyphthalic anhydride, 3-methylphthalic anhydride, 3-phenylphthalic anhydride, trimellitic anhydride, pyromellitic anhydride, maleic anhydride, phenylmaleic anhydride, dimethylmaleic anhydride, dichloromaleic anhydride, and chloromaleic anhydride.

The cyclic acid anhydride content, in each case expressed with reference to the total solids content of the image-forming layer, is preferably 0.5 to 20 % by weight, more preferably 1 to 15 % by weight, and most preferably 1 to 10 % by weight. The ability to preserve the developability may be inadequate at a content of less than 0.5 % by weight, while image formation may not be possible at more than 20 weight%.

The following are components present in the recording layer of a negative-acting lithographic printing plate.

### - (E) A compound that generates acid under the application of heat -

When the image-forming material is a negative-acting material, a compound that generates acid when heated (referred to hereafter as an acid generator) is also used. This acid generator is decomposed by heating to 100°C or more to increase the acid-generating compound. The generated acid is preferably a strong acid with a pKa of 2 or less, for example, sulfonic acid, hydrochloric acid, and so forth.
Suitable examples of this acid generator are onium salts such as iodonium salts, sulfonium salts, phosphonium salts, diazonium salts, and so forth. Specific examples are the compounds described in United States Patent No. 4,708,925 and Japanese Patent Application Publication No. H7-20629A, whereamong iodonium salts, sulfonium salts, and diazonium salts having a sulfonate ion as the counterion are preferred.
Other suitable examples of the aforementioned diazonium salts are the diazonium salt compounds described in United States Patent No. 3,867,147, the diazonium compounds described in United States Patent No. 2,632,703, and the diazo resins described in Japanese Patent Application Publication Nos. H1-102456A and 1-102457A.
Also preferred are the benzyl sulfonates described in United States Patent Nos. 5,135,838 and 5,200,544 and the active sulfonate esters and disulfonium compounds described in Japanese Patent Application Publication Nos. H2-100054A, 2-100055A, and 8-9444A. Also preferred are the haloalkyl-substituted s-triazines described in Japanese Patent Application Publication No. H7-271029A.
The quantity of acid generator addition, in each instance expressed with reference to the weight of the total solids fraction in the image-forming layer, is preferably 0.01 to 50 % by weight, more preferably 0.1 to 40 % by weight, and most preferably 0.5 to 30 % by weight.

### - (F) The crosslinking agent that crosslinks under the action of acid -

A crosslinking agent that crosslinks under the action of acid (in some instances referred to hereafter simply as the crosslinking agent) is also used when the lithographic printing plate precursor is a negative-acting type.
This crosslinking agent can be exemplified by the following.
(i) aromatic compounds substituted by the alkoxymethyl group or hydroxymethyl group
(ii) compounds having an N-hydroxymethyl group, N-alkoxymethyl group, or N-acyloxymethyl group
(iii) epoxy compounds

Other examples are phenol derivatives and the crosslinking agents described in Japanese Patent Application Publication No. H11-254850A.

The quantity of crosslinking agent addition, in each instance expressed with reference to the weight of the total solids fraction in the image-forming layer, is preferably 5 to 80 % by weight, more preferably 10 to 75 % by weight, and most preferably 20 to 70 % by weight.

When the aforementioned phenol derivative is used as the crosslinking agent, the quantity of addition of thephenol derivative, in each case expressed with reference to the weight of the total solids fraction in the image-forming material, is preferably 5 to 70 % by weight and more preferably is 10 to 50 % by weight.

The details of the various compounds cited above are given in Japanese Patent Application Publication No. 2000-267265.

### - Other components -

A variety of additives can also be added on an optional basis to the image-forming layer of the lithographic printing plate precursor.

For example, a known additive such as a phenol, organic acid, sulfonyl compound, and so forth, can also be used for the purpose of raising the sensitivity.

The phenol can be exemplified by bisphenol A, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane, and 4,4',3",4"-tetrahydroxy-3,5,3',5'-tetramethyltriphenylmethane.

The aforementioned organic acid can be a sulfonic acid, sulfinic acid, alkylsulfuric acid, phosphonic acid, phosphate ester, or carboxylic acid, each as described in Japanese Patent Application Publication Nos. S60-88942A and H2-96755A. Specific examples are p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 4-cyclohexene-2,2-dicarboxylic acid, erucic acid, lauric acid, n-undecanoic acid, and ascorbic acid.

The sulfonyl compound can be exemplified by bishydroxyphenyl sulfone, methyl phenyl sulfone, and diphenyl disulfone.

The quantity of addition of the phenol, organic acid, or sulfonyl compound, in each instance expressed with reference to the weight of the total solids fraction of the image-forming layer, is preferably 0.05 to 20 % by weight, more preferably 0.1 to 15 % by weight, and most preferably 0.1 to 10 % by weight.

With the goal of broadening the processing stability with respect to the development conditions, a siloxane-type compound as described in EP 950517 or a fluorinated monomer copolymer as described in Japanese Patent Application Publication No. H11-288093A can be added.

The siloxane-type compound is preferably a block copolymer of dimethylsiloxane and polyalkylene oxide and can be specifically exemplified by polyalkylene oxide-modified silicones such as DBE-224, DBE-621, DBE-712, DBP-732, and DBP-534 from Chisso Corporation and Tego Glide 100 from the German firm, Tego.

The use amount for this surfactant, in each instance expressed with reference to the weight of the total solids fraction of the image-forming layer, is preferably 0.05 to 15 % by weight and more preferably is 0.1 to 5 % by weight.

The image-forming layer can contain a dye or pigment functioning as an image colorant or print-out agent for the purpose of obtaining a visible image immediately after the photoexposure-induced heating.

This print-out agent can be, for example, the combination of an organic dye capable of forming a salt and a compound that generates acid due to the photoexposure-induced heating.

Specific examples are the combination of a salt-forming organic dye with o-naphthoquinonediazide-4-sulfonyl halide, as described in Japanese Patent Application Publication Nos. S50-36209A and 53-8128A, and the combination of a trihalomethyl compound and a salt-forming organic dye, as described in Japanese Patent Application Publication Nos. S53-36223A, 54-74728A, 60-3626A, 61-143748A, 61-151644A, and 63-58440A.

The trihalomethyl compound can be an oxazole-type compound or a triazine-type compound, and each of these exhibits an excellent temporal stability and provides a clear, sharp printed-out image.

The image colorant can be, for example, the salt-forming organic dye already cited above, but other dyes can also be used, for example, oil-soluble dyes and basic dyes are suitable.

Specific examples are Oil Yellow #101, Oil Yellow #103, Oil Pink #312, Oil Green BG, Oil Blue BOS, Oil Blue #603, Oil Black BY, Oil Black BS, and Oil Black T-505 (all of the preceding from Orient Chemical Industries, Ltd.), as well as Victoria Pure Blue, Crystal Violet (C.I. 42555), Methyl Violet (C.I. 42535), Ethyl Violet, Rhodamine B (C.I. 145170B), Malachite Green (C.I. 42000), Methylene Blue (C.I. 52015), and so forth. The dyes described in Japanese Patent Application Publication No. S62-293247A are particularly preferred.

The quantity of addition of these various dyes, in each instance expressed with reference to the weight of the total solids fraction of the image-forming layer, is preferably 0.01 to 10 % by weight and more preferably 0.1 to 3 % by weight.

A plasticizer can be added as necessary for the purpose of imparting flexibility to the coated film.

The plasticizer can be exemplified by butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, and oligomers and polymers of acrylic acid and methacrylic acid.

The various additives described below can also be added on an optional basis.

For example, compounds can be used that are thermally decomposable and that, in their undecomposed state, substantially reduce the solubility of the aqueous alkali-soluble polymer compound; examples of such compounds are onium salts, o-quinonediazide compounds, aromatic sulfone compounds, aromatic sulfonate ester compounds and so forth. The addition of these compounds is preferred for the purpose of improving the capacity to prevent the image areas from dissolving in the developing solution.

The onium salts can be exemplified by diazonium salts, ammonium salts, phosphonium salts, iodonium salts, sulfonium salts, selenonium salts, arsonium salts and so forth.

Examples thereamong are the diazonium salts described in S. I. Schlesinger, Photogr. Sci. Eng., 18, 387 (1974), T. S. Bal et al., Polymer, 21, 423 (1980), and Japanese Patent Application Publication No. S5-158230A; the ammonium salts described in United States Patent Nos. 4,069,055 and 4,069,056 and Japanese Patent Application Publication No. H3-140140A; the phosphonium salts described in D. C. Necker et al., Macromolecules, 17, 2468 (1984), C. S. Wen et al., The Proc. Conf. Rad. Curing, ASIA, p. 478, Tokyo, October (1988), and United States Patent Nos. 4,069,055 and 4,069,056; the iodonium salts described in J. V. Crivello et al., Macromolecules, 10(6), 1307 (1977), Chem. & Eng. News, November 28, p. 31 (1988), European Patent No. 104,143, United States Patent Nos. 339,049 and 410,201, and Japanese Patent Application Publication Nos. H2-150848A and 2-296514A; the sulfonium salts described in J. V. Crivello et al., Polymer J., 17, 73 (1985), J. V. Crivello et al., J. Org. Chem., 43, 3055 (1978), W. R. Watt et al., J. Polymer Sci., Polymer Chem. Ed., 22, 1789 (1984), J. V. Crivello et al., Polymer Bull., 14, 279 (1985), J. V. Crivello et al., Macromolecules, 14(5), 1141 (1981), J. V. Crivello et al., J. Polymer Sci., Polymer Chem. Ed., 17, 2877 (1979), European Patent Nos. 370,693, 233,567, 297,443 and 297,442, United States Patent Nos. 4,933,377, 3,902,114, 410,201, 339,049, 4,760,013, 4,734,444 and 2,833,827, and German Patent Nos. 2,904,626, 3,604,580 and 3,604,581; the selenonium salts described in J. V. Crivello et al., Macromolecules, 10(6), 1307 (1977) and J. V. Crivello et al., J. Polymer Sci., Polymer Chem. Ed., 17, 1047 (1979); and the arsonium salts described in C. S. Wen et al., The Proc. Conf. Rad. Curing, ASIA, p.478, Tokyo, October (1988).

The diazoniums salt are preferred among the preceding, and the diazonium salts described in Japanese Patent Application Publication No. H5-158230A are particularly preferred.

The counterion in the onium salt can be exemplified by tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesufonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid, and p-toluenesulfonic acid.

The following are preferred among the preceding: hexafluorophosphoric acid and alkyl aromatic sulfonic acids such as triisopropylnaphthalenesulfonic acid and 2,5-dimethylbenzenesulfonic acid.

The aforementioned o-quinonediazide compound is exemplified by compounds that contain at least one o-quinonediazide group and that undergo an increase in alkali solubility upon thermal decomposition, and compounds having various structures can be used.

This o-quinonediazide, upon thermal decomposition, loses its dissolution inhibiting function for the binder and also itself is converted into an alkali-soluble substance, and it assists the solubility of the lithographic printing plate precursor through both effects.

The compounds described in J. Kosar, "Light-Sensitive Systems", pp. 339 to 352 (John Wiley & Sons, Inc.) can be used as the o-quinonediazide compounds under consideration, and preferred thereamong are the sulfonate esters and sulfonamides of o-quinonediazides that have been reacted with various aromatic polyhydroxy compounds or aromatic amino compounds.

Also preferred are the esters of phenol-formaldehyde resin with benzoquinone-(1,2)-diazidosulfonyl chloride as described in Japanese Patent Application Publication No. S43-28403A and the esters of phenol-formaldehyde resin with benzoquinone-(1,2)-diazidosulfonyl chloride or naphthoquinone-(1,2)-diazido-5-sulfonyl chloride as described in United States Patent Nos. 3,046,120 and 3,188,210.

Also preferred are the esters of naphthoquinone-(1,2)-diazido-4-sulfonyl chloride and a phenol-formaldehyde resin or a cresol-formaldehyde resin and esters of naphthoquinone-(1,2)-diazido-4-sulfonyl chloride and a pyrogallol-acetone resin.

In addition to the preceding, the compounds described in the following are also useful: Japanese Patent Application Publication Nos. S47-5303A, 48-63802A, 48-63803A, 48-96575A, 49-38701A, and 48-13354A; Japanese Patent Publication Nos. S41-11222, 45-9610, and 49-17481; United States Patent Nos. 2,797,213, 3,454,400, 3,544,323, 3,573,917, 3,674,495, and 3,785,825; British Patent Nos. 1,227,602, 1,251,345, 1,267,005, 1,329,888, and 1,330,932; and German Patent No. 854,890.

A single one of these compounds may be used or mixtures combining a plurality of these compounds may be used.

The quantity of addition of the above-described onium salt, o-quinonediazide compound, aromatic sulfonate ester, and so forth is preferably 0.1 to 50 % by weight, more preferably 0.5 to 30 % by weight, and most preferably 0.5 to 20 % by weight, expressed in each case with reference to the weight of the total solids fraction of the image-forming layer.

With the goal of strengthening the image discrimination and strengthening the capacity to resist scratching of the surface, a polymer is preferably also used that has as a polymerization component therein a (meth)acrylate monomer that contains two or three C₃ to C₂₀ perfluoroalkyl groups in the molecule, as described in Japanese Patent Application Publication No. 2000-187318. Its quantity of addition, expressed in each case with reference to the weight of the total solids fraction of the image-forming layer, is preferably 0.1 to 10 % by weight and more preferably is 0.5 to 5 % by weight.

A compound that lowers the static coefficient of friction of the surface may also be added with the goal of imparting scratch resistance. A specific example is the ester of a long-chain alkylcarboxylic acid, as disclosed in United States Patent No. 6,117,913. Its quantity of addition, expressed in each case with reference to the weight of the total solids fraction of the image-forming layer, is preferably 0.1 to 10 % by weight and more preferably is 0.5 to 5 % by weight.

Various dissolution inhibitors may also be added with the goal of adjusting the solubility of the image-forming layer. The disulfone compound or sulfone compound described in Japanese Patent Application Publication No. H11-119418A is suitable for use as this dissolution inhibitor, and in specific terms the use of 4,4'-bishydroxyphenyl sulfone is preferred. Its quantity of addition, expressed in each case with reference to the weight of the total solids fraction of the image-forming layer, is preferably 0.05 to 20 % by weight and more preferably is 0.5 to 10 % by weight.

The lithographic printing plate precursor disclosed in Japanese Patent Application Publication No. 2002-182400 is another specific example of the photosensitive lithographic printing plate; in this lithographic printing plate precursor, the image-forming layer is a positive-acting heat-sensitive layer that has a two-layer structure. Thus, this positive-acting heat-sensitive layer characteristically has a laminate structure in which a heat-sensitive layer is disposed in a position near the surface (photoexposed side) and an underlayer comprising an alkali-soluble polymer compound is disposed on the side near the support. Either or both of this heat-sensitive layer and underlayer can contain, as described hereinabove, (A) an infrared-absorbing dye; (B) an alkali-soluble polymer compound; (C) a compound that is compatible with the alkali-soluble polymer compound, that reduces the solubility of this base-soluble polymer compound in aqueous alkali solutions, and that undergoes a decline in its solubility-suppressing function when heated; and the - other components -.

Viewed from the perspective of image formation during development, the alkali-soluble polymer compound used for the underlayer is preferably an acrylic resin because this makes it possible to maintain good solubility for the underlayer in basic developing solutions whose main components are base and an organic compound that exhibits a buffering function. Acrylic resin that contains the sulfoamide group is particularly preferred for this acrylic resin. Viewed from the standpoints of creating strong hydrogen bonding in the unexposed areas and of being able to easily extinguish a portion of the hydrogen bonds in the exposed areas, the alkali-soluble polymer compound used for the heat-sensitive layer is desirably a resin that contains the phenolic hydroxyl group. Novolac resins are particularly preferred.

An infrared-absorbing dye can be added not only to the heat-sensitive layer, but also to the underlayer. The underlayer can itself also be made to function as a heat-sensitive layer by the addition of an infrared-absorbing dye to the underlayer. When an infrared-absorbing dye is added to the underlayer, the same substance as in the overlying heat-sensitive layer may be used or a different substance may be used.

The other additives may be present only in the underlayer, or only in the heat-sensitive layer, or in both layers.

The individual components as described above of the image-forming layer (including the two-layer structure described above) of the lithographic printing plate precursor can be dissolved in solvent and coated on a suitable support. The solvent can be exemplified by ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, α-butyrolactone, toluene, and so forth, but there is no limitation to the preceding. A single solvent may be used or two or more may be used in combination.

When the image-forming layer is executed as a two-layer structure, alkali-soluble polymer compounds with different solubilities are preferably selected for the alkali-soluble polymer compound used in the heat-sensitive layer and the base-soluble polymer compound used in the underlayer. Thus, when a solvent that can dissolve the alkali-soluble polymer compound in the underlayer is used as the application solvent for the uppermost layer during application - after application of the underlayer - of the heat-sensitive layer that is the overlying layer adjacent thereto, mixing at the layer interface will no longer be insignificant and, in extreme cases, a single uniform layer may be obtained rather than two layers. As a consequence, the solvent used to apply the upper heat-sensitive layer is preferably a poor solvent for the base-soluble polymer compound present in the underlayer.

The total solids concentration of the above-described components in the solvent at the time of application of the image-forming layer is generally preferably 1 to 50 % by weight.

The dry coating quantity (solids) for the image-forming layer that is produced by coating and drying on the support is preferably generally 0.5 to 5.0 g/m². In the case of a two-layer structure, this value is preferably 0.05 to 1.0 g/m² for the heat-sensitive layer and is preferably 0.3 to 3.0 g/m² for the underlayer. While smaller coating quantities do provide a higher apparent sensitivity, they also result in reduced film properties for the image-forming layer.

The method for coating the support can be selected as appropriate from the various known methods; for example, bar coater application, spin coating, spray coating, curtain coating, dip coating, air knife coating, blade coating, roll coating, and so forth can be used.

Surfactant can be added to the image-forming layer coating solution with the goal of improving the coatability, for example, the fluorosurfactant described in Japanese Patent Application Publication No. S62-170950A can be added. Its quantity of addition, expressed in each case with reference to the weight of the total solids fraction of the image-forming layer, is preferably 0.01 to 1 % by weight and more preferably 0.05 to 0.5 % by weight.

### [Photopolymerizable photosensitive lithographic printing plates]

The image recording layer of a photopolymerizable photosensitive lithographic printing plate generally comprises (A) a radical generator (radical polymerization initiator) and (B) a radically polymerizable compound that cures via a polymerization reaction induced by the generated radicals. In such an image recording layer, the radical polymerization initiator (A) is decomposed by exposure to light with the generation of radicals. The radically polymerizable compound (B) is selected from compounds that have at least one ethylenically unsaturated double bond and at least one and preferably at least two terminal ethylenically unsaturated bonds; the generated radicals cause a chain polymerization reaction that results in curing and formation of the image areas. The constituent components of the image recoding layer are described in the following.

### (A) The radical generator

Examples of radical generators suitable for use include s-triazine having a trihalomethyl group, borate salts, onium salts and so forth. Examples of the onium salts are iodonium salts, diazonium salts, and sulfonium salts. While these onium salts can also function as acid generators, they function as an initiator of radical polymerization when used in combination with the radically polymerizable compound, infra. In particular, when combined with an infrared absorber, infra, the radical polymerization initiator, e.g., onium salt, undergoes heat-induced decomposition in heated or photoexposed regions with the generation of radicals. The onium salts represented by the following general formulas (1) to (3) are onium salts suitable for use.

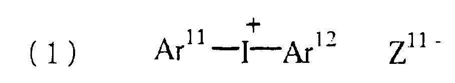

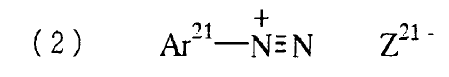

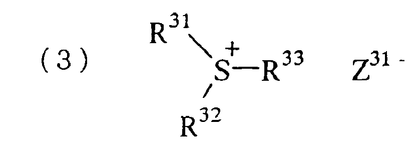

Ar¹¹ and Ar¹² in formula (1) each independently represent a possibly substituted aryl group having 20 or less carbon atoms. When this aryl group is substituted, preferred substituents are, for example, halogen atoms, the nitro group, alkyl group having 12 or less carbon atoms, alkoxy group having 12 or less carbon atoms, and aryloxy group having 12 or less carbon atoms. Z¹¹⁻ represents a counterion, for example, a halide ion, the perchlorate ion, the tetrafluoroborate ion, a carboxylate ion, the hexafluorophosphate ion, a sulfonate ion, and so forth, and is preferably the perchlorate ion, a carboxylate ion, or an arylsulfonate ion.

Ar²¹ in formula (2) is a possibly substituted aryl group having 20 or less carbon atoms. Preferred substituents are, for example, halogen atoms, the nitro group, alkyl group having 12 or less carbon atoms, alkoxy group having 12 or less carbon atoms, aryloxy group having 12 or less carbon atoms, alkylamino group having 12 or less carbon atoms, dialkylamino group having 12 or less carbon atoms, arylamino group having 12 or less carbon atoms, and diarylamino group having 12 or less carbon atoms. Z²¹⁻ represents a counterion with the same definition as for Z¹¹⁻.

R³¹, R³², and R³³ in formula (3) are same or different, and each independently represent possibly substituted hydrocarbon radical having 20 or less carbon atoms. Preferred substituents are, for example, halogen atoms, the nitro group, alkyl group having 12 or less carbon atoms, alkoxy group having 12 or less carbon atoms, and aryloxy group having 12 or less carbon atoms. Z³¹represents a counterion with the same definition as for Z¹¹⁻.

The following are specific examples of onium salts suitable for use, but the present invention is not limited to these.

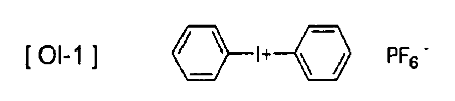

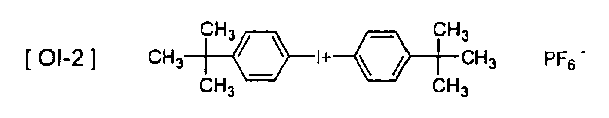

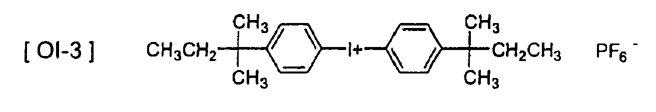

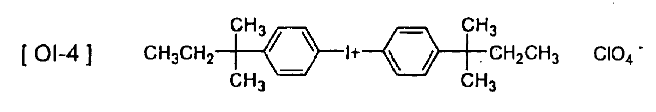

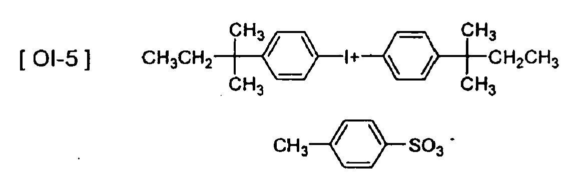

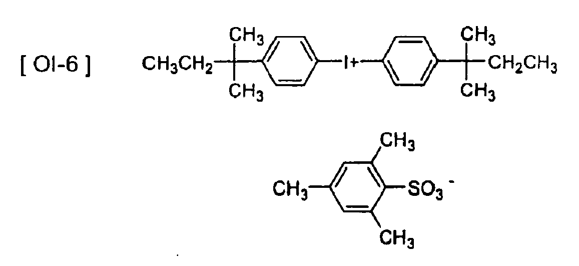

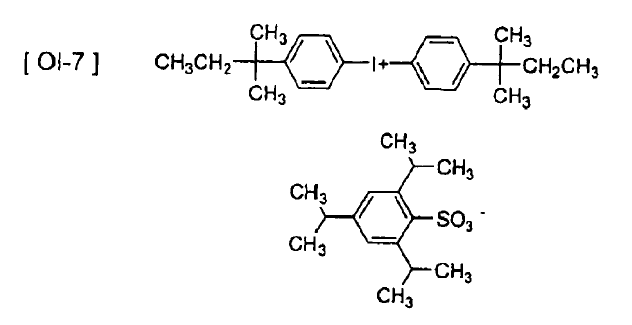

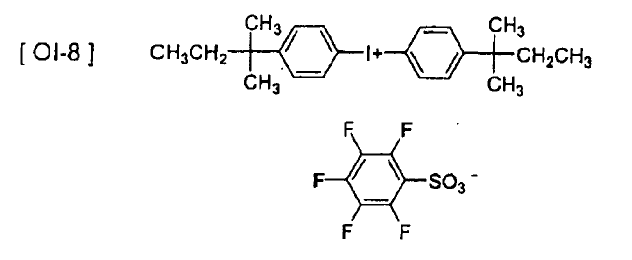

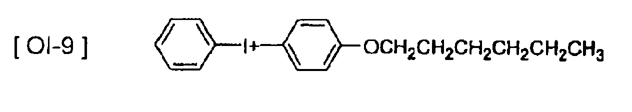

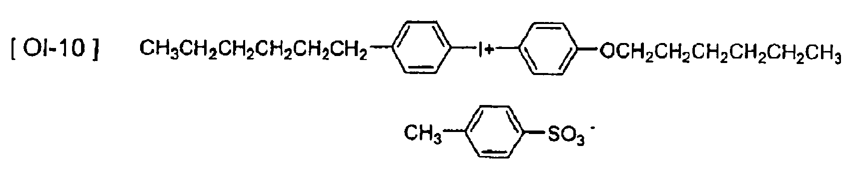

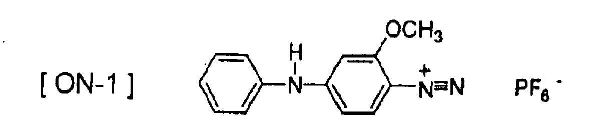

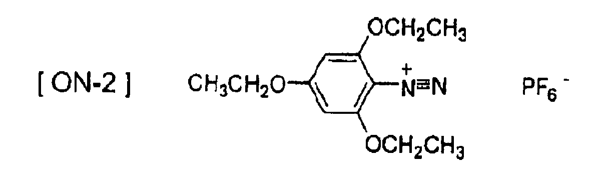

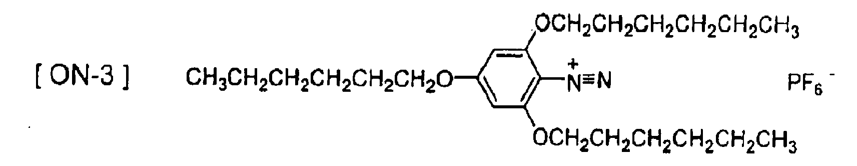

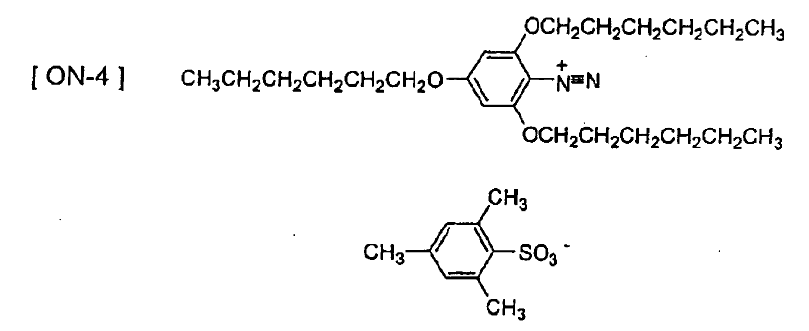

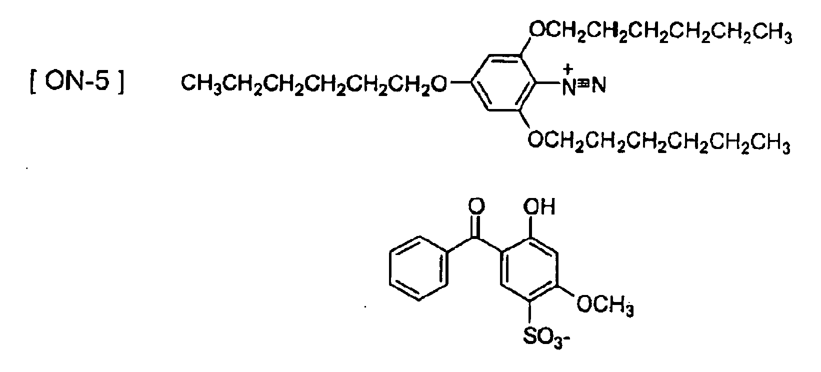

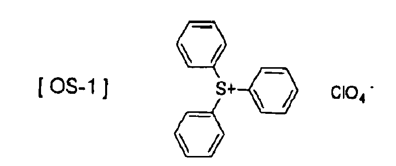

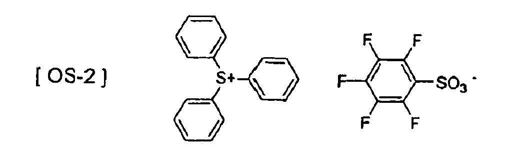

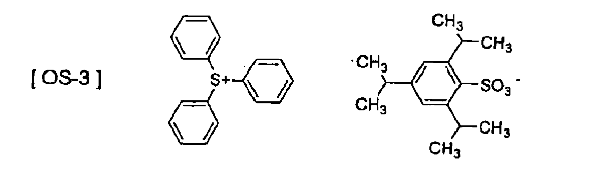

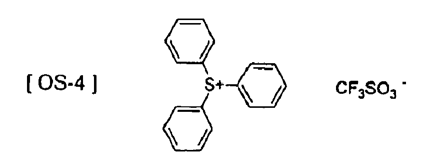

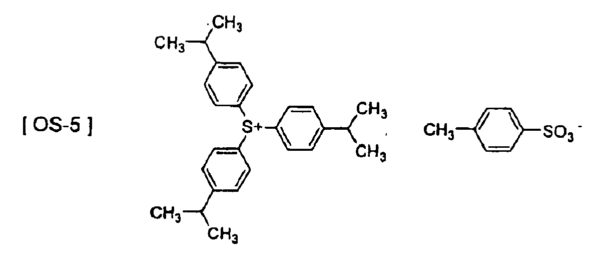

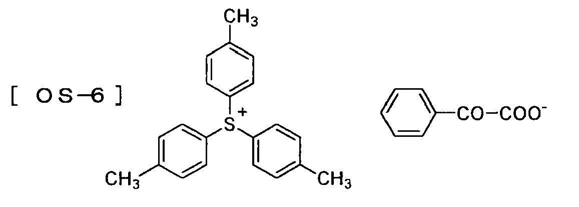

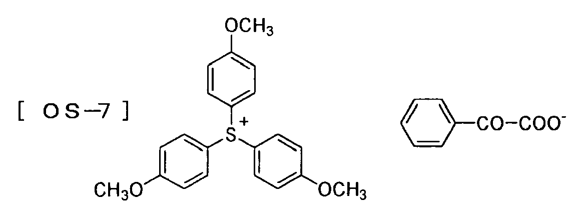

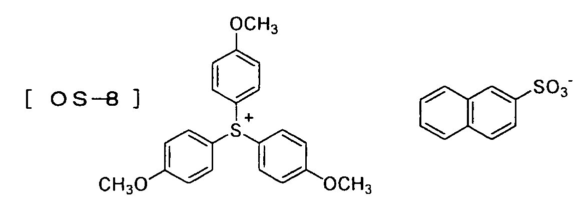

The maximum absorption wavelength for the radical generator is preferably less than or equal to 400 nm and more preferably is less than or equal to 360 nm. Bringing this absorption wavelength into the ultraviolet region makes it possible to handle the lithographic printing plate precursor under white lighting.

This radical generator can be added to the image recording layer coating solution in a proportion that is 0.1 to 50 % by weight, preferably 0.5 to 30 % by weight, and particularly preferably 1 to 20 % by weight with reference to the total solids fraction of the image recording layer coating solution. The sensitivity is low when this quantity of addition is less than 0.1 % by weight, while scumming in the non-image areas during printing occurs when this quantity of addition exceeds 50 % by weight. Only a single radical generator may be used or two or more may be used in combination. The radical generator may be added to the same layer as the other components, or a separate layer may be provided and the radical generator may be added thereto.

### (B) The radically polymerizable compound

The radically polymerizable compound used in the image recording layer is a radically polymerizable compound that contains at least one ethylenically unsaturated double bond and is selected from compounds that have at least one and preferably at least two terminal ethylenically unsaturated bonds. Compounds in this group are widely known in the pertinent industrial sectors and these can be used without any particular limitations. In terms of their chemical configuration, they may be, for example, a monomer, prepolymer (i.e., dimer, trimer, or oligomer), mixtures of the preceding, and copolymers of the preceding. The monomers and copolymers thereof can be exemplified by unsaturated carboxylic acids (e.g., acrylic acid, methacrylic acid, itaconic acid, crotonic acid, isocrotonic acid, maleic acid) and by esters and amides thereof; the use is preferred of esters between an unsaturated carboxylic acid and an aliphatic polyhydric alcohol compound and amides between an unsaturated carboxylic acid and an aliphatic polyfunctional amine compound. Also suitable for use are addition reaction products between an unsaturated carboxylic acid ester or amide that has a nucleophilic substituent (e.g., the hydroxyl group, amino group, mercapto group, and so forth) and a monofunctional or polyfunctional isocyanate or epoxy compound, and the dehydration/condensation reaction products between an unsaturated carboxylic acid ester or amide that has a nucleophilic substituent (e.g., the hydroxyl group, amino group, mercapto group, and so forth) and a monofunctional or polyfunctional carboxylic acid. Also suitable for use are addition reaction products between an unsaturated carboxylic acid ester or amide that has an electrophilic substituent (e.g., the isocyanate group, epoxy group, and so forth) and a monofunctional or polyfunctional alcohol, amine, or thiol, as well as the substitution reaction products from an unsaturated carboxylic acid ester or amide that has a leaving group (e.g., halogen group, tosyloxy group, and so forth) and a monofunctional or polyfunctional alcohol, amine, or thiol. The groups of compounds obtained by replacing the unsaturated carboxylic acid in the preceding with, e.g., unsaturated phosphonic acid, styrene, and so forth, can also be used.

Specific examples of the radically polymerizable compounds that are aliphatic polyhydric alcohol compound/unsaturated carboxylic acid esters are acrylate esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, polyester acrylate oligomer and so forth.

Other examples are methacrylate esters such as tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, bis[p-(methacryloxyethoxy)phenyl]dimethylmethane and so forth.

Additional examples are itaconate esters such as ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate and so forth.

Further examples are crotonate esters such as ethylene glycol dicrotonate, tetramethylene glycol dicrotonate, pentaerythritol dicrotonate, sorbitol tetradicrotonate and so forth.

Additional examples are isocrotonate esters such as ethylene glycol diisocrotonate, pentaerythritol diisocrotonate, and sorbitol tetraisocrotonate.

Still other examples are maleate esters such as ethylene glycol dimaleate, triethylene glycol dimaleate, pentaerythritol dimaleate, sorbitol tetramaleate and so forth.

Examples of other esters suitable for use are the aliphatic alcohol-type esters described in Japanese Patent Publication Nos. S46-27926 and 51-47334 and Japanese Patent Application Publication No. S57-196231A; the aromatic skeleton-containing esters described in Japanese Patent Application Publication Nos. S59-5240A and 59-5241A and H2-226149A; and the amino group-containing esters described in Japanese Patent Application Publication No. H1-165613A.

Urethane-type addition polymerizable compounds produced using the addition reaction between isocyanate and hydroxyl are also suitable, and specific examples in this regard are the vinyl urethane compounds that have at least two polymerizable vinyl groups per molecule, as obtained by the addition of the hydroxyl-functional vinyl monomer represented by the following general formula (4) to a polyisocyanate compound that has at least two isocyanate groups per molecule, as described in Japanese Patent Publication No. S48-41708.

CH₂=C(R⁴¹)COOCH₂CH(R⁴²)OH general formula (4)

(R⁴¹ and R⁴² represent H or CH₃)

The details of the application of these radically polymerizable compounds, such as what structure is to be used, whether they are used individually or in combination, and what amount of addition is to be used, can be freely established in conformity with the intended performance of the ultimate recording material. Selection can be made, for example, based on the following considerations. From the standpoint of the sensitivity, a structure is preferred that has a rich unsaturated group content per molecule, and at least difunctional is preferred in many cases. In order to raise the strength of the image area, i.e., the cured film, at least trifunctional is desirable. Moreover, an effective method for adjusting both the sensitivity and strength is to use combinations of compounds that have different numbers of functionalities and different polymerizable groups (e.g., acrylate ester-type compounds, methacrylate ester-type compounds, styrenic compounds, and so forth). High molecular weight compounds and highly hydrophobic compounds provide an excellent sensitivity and film strength; however, they may be undesirable with regard to development speed and precipitation in the developing solution. In addition, the selection of the radically polymerizable compound and its method of use are important factors with regard to the compatibility and dispersibility with the other components in the image recording layer (e.g., the binder polymer, initiator, colorant, etc.). For example, the compatibility can be improved by the use of a low purity compound or by the combined use of two or more compounds. A specific structure can also be selected for the purpose of improving the adhesiveness with, for example, the support or an overcoating layer. With regard to the proportion of the radically polymerizable compound in the image recording layer, a large proportion is advantageous for the sensitivity; however, an overly large proportion can produce problems such as an undesirable phase separation, production issues caused by the tackiness of the image recording layer (for example, production defects caused by transfer of and tackiness by the recording layer components), and precipitation from the developing solution.

Based on these considerations, the preferred proportion for the radically polymerizable compound is in many cases 5 to 80 % by weight and preferably 20 to 75 % by weight, in each instance with reference to the total of the components in the composition. A single radically polymerizable compound may be used or two or more may be used in combination. Otherwise, the radically polymerizable compound is deployed by freely selecting a suitable structure, incorporation, and quantity of addition in view of, for example, the magnitude of oxygen inhibition of polymerization, the resolution, the fogging properties, the refractive index change, surface tackiness, and so forth. Moreover, a layer structure and coating method, such as a lower coating and an upper coating, can also be implemented depending on the circumstances.

### (C) The light absorber

A light absorber is preferably present in the image recording layer given that image formation is carried out in response to ultraviolet, visible, or infrared radiation. The light absorber used is a compound that absorbs ultraviolet, visible, or infrared radiation and generates radicals through the combination with the radical generator.

For this combination, acetophenone types, benzoin types, benzophenone types, and thioxanthone types are examples of initiators that exhibit sensitivity in the ultraviolet region.

The following are examples of initiators that exhibit sensitivity in the visible region: the combination of chlorophyll with an organic peroxide, the combination of eosin G with an organic peroxide, the combination of riboflavin with an organic peroxide, the combination of Methylene Blue with an organic peroxide, the combination of a (thio)pyrylium salt with an organic peroxide, the combination of a merocyanine with an organic peroxide, the combination of a quinoline with an organic peroxide, the combination of a styrylquinone with an organic peroxide, the combination of a (thio)xanthene dye with an organic peroxide, the combination of riboflavin tetrabutyrate with an organic peroxide, the combination of a (keto)coumarin dye with an organic peroxide, the combination of a thioxanthene dye with an organic peroxide and N-phenylglycine, the combination of a diphenyliodonium salt with a merocyanine dye, the combination of a diphenyliodonium salt with a rhodanine derivative polymer, the combination of a diphenyliodonium salt with a ketocoumarin dye, the combination of a diphenyliodonium salt with a tetraphenylporphyrin, the combination of a diphenyliodonium salt with a tetrabenzoporphyrin, the combination of a diphenyliodonium salt with a spiropyran, the combination of a diphenyliodonium salt with N-phenylglycine and a thioxanthene dye, the combination of a diphenyliodonium salt with N-phenylglycine and a merocyanine dye, a cyanine dye, an alkylborate salt of a cyanine dye, an alkylborate salt of a rhodamine dye, an alkylborate salt of a Methylene Blue-type dye, an iron/arene complex, the combination of an iron/arene complex with a ketocoumarin dye, the combination of an iron/arene complex with a thioxanthene dye, a titanocene, the combination of a titanocene with a merocyanine dye, the combination of a bisimidazole and an arylylidene aryl ketone, the combination of a bisimidazole and a ketocoumarin dye, the combination of N-phenylglycine and a ketocoumarin dye, the combination of N-phenylglycine and a (thio)xanthene dye, tris(trichloromethyl)-s-triazine derivatives, the combination of a tris(trichloromethyl)-s-triazine derivative with a merocyanine dye, the combination of a tris(trichloromethyl)-s-triazine derivative with a ketocoumarin dye, the combination of a tris(trichloromethyl)-s-triazine derivative with a thiopyrylium salt, the combination of a tris(trichloromethyl)-s-triazine derivative with a thioxanthene dye, the combination of an aminobenzoate ester with riboflavin tetrabutyrate, and the combination of 2-mercaptobenzimidazole with a thiopyrylium salt.

Examples of initiators that exhibit near infrared sensitivity are the borate salts of near infrared-absorbing cation dyes, combinations of borate salts with near infrared-absorbing cation dyes, and combinations of triazine compounds with near infrared-absorbing cation dyes.

When recording is done with a laser that generates infrared radiation, in order to increase the sensitivity of the image recording layer of the image recording material, a light absorber is preferably added that has the ability to convert the infrared light used for photoexposure to heat. Such a light absorber is preferably a dye or pigment that has an absorption maximum in particular at a wavelength from 760 nm to 1200 nm. Light absorbers that exhibit absorption in the infrared region (infrared absorbers) are described in the following.

This dye can be a commercial dye or a known dye as described in the literature, for example, "The Dye Handbook" (The Society of Synthetic Organic Chemistry, Japan (1970)). Specific examples are the dyes described in sections [0050] and [0051] of Japanese Patent Application Publication No. H10-39509A.

Particularly preferred among these dyes are cyanine dyes, squarylium dyes, pyrylium salts, and nickel/thiolate complexes. Cyanine dyes are more preferred, and in particular cyanine dyes with the following general formula (5) are most preferred.

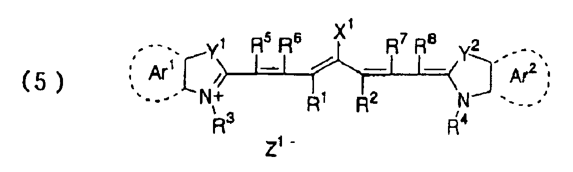

X¹ in general formula (5) is a halogen atom, X²-L¹, or NL²L³. X² represents an oxygen atom or sulfur atom; L¹ represents C₁ to C₁₂ hydrocarbon radical; and L² and L³ each independently represent C₁ to C₁₂ hydrocarbon radical. R¹ and R² each independently represent C₁ to C₁₂ hydrocarbon radical. Based on a consideration of the storage stability of the recording layer coating solution, R¹ and R² are preferably hydrocarbon radical having at least two carbon atoms and R¹ and R² are particularly preferably bonded to each other with the formation of a five-membered or six-membered ring.

Ar¹ and Ar² are the same or different, and each independently represent possibly substituted aromatic hydrocarbon radical. Y¹ and Y² each independently represent the sulfur atom or a dialkylmethylene group that has 12 or less carbon atoms. R³ and R⁴ are the same or different, and each independently represent possibly substituted hydrocarbon radical having 20 or less carbon atoms. Preferred substituents are alkoxy group having 12 or less carbon atoms, the carboxyl group, and the sulfo group. R⁵, R⁶, R⁷, and R⁸ are the same or different, and each independently represent the hydrogen atom and hydrocarbon radical having 12 or less carbon atoms. The hydrogen atom is preferred based on the ease of starting material acquisition. Z¹- represents a counteranion. However, Z¹- is not required when the sulfo group is substituted on any of R¹ to R⁸. Based on a consideration of the storage stability of the recording layer coating solution, Z¹- is preferably a halogen ion, the perchlorate ion, the tetrafluoroborate ion, the hexafluorophosphate ion, or a sulfonate ion and particularly preferably is the perchlorate ion, the trifluoromethylsulfonate ion, or an arylsulfonate ion.

Specific examples of cyanine dyes with general formula (5) that are suitable for use are provided below, but there is no limitation to these.

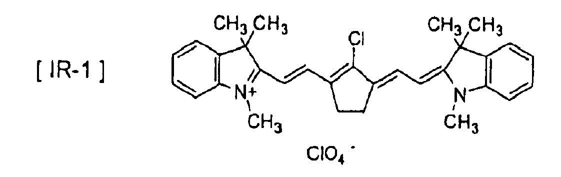

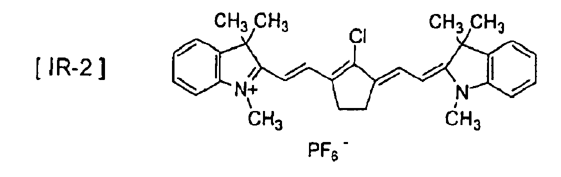

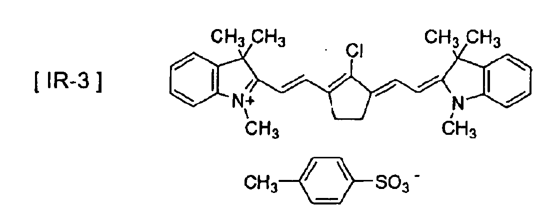

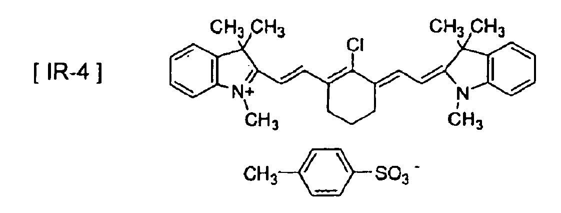

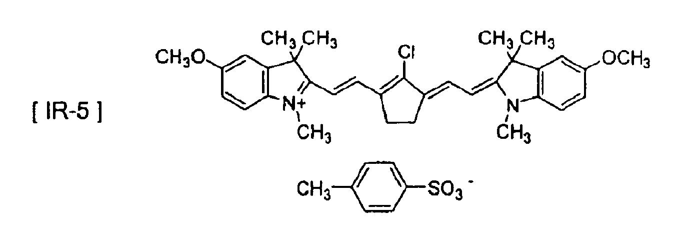

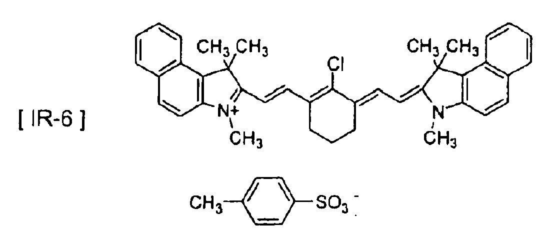

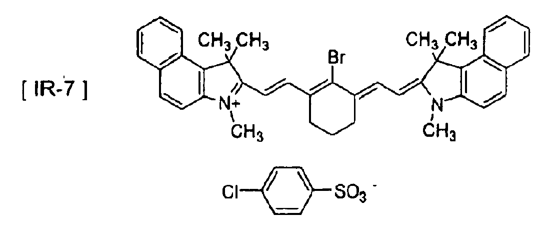

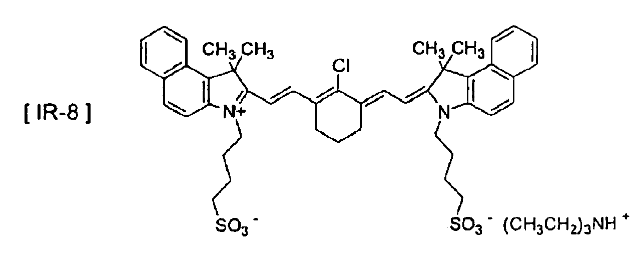

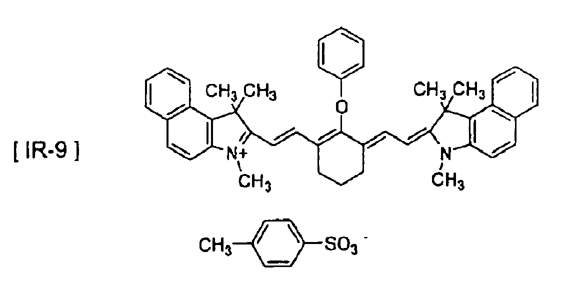

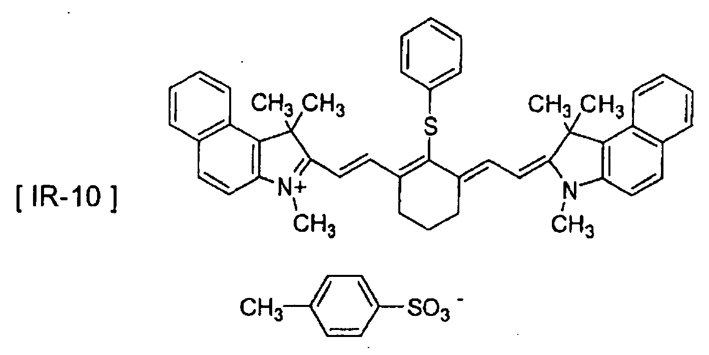

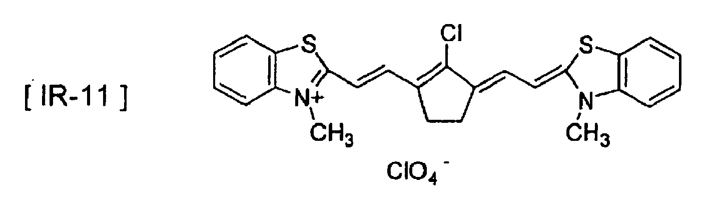

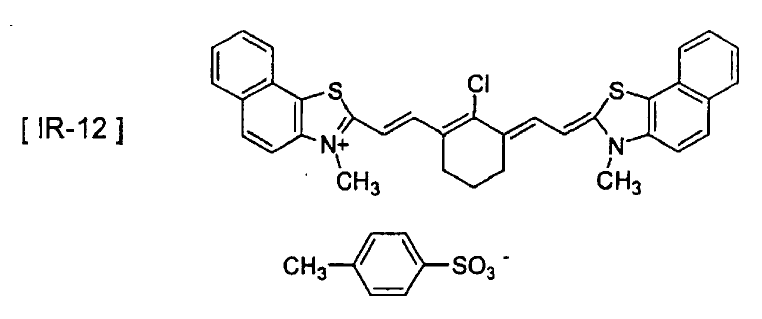

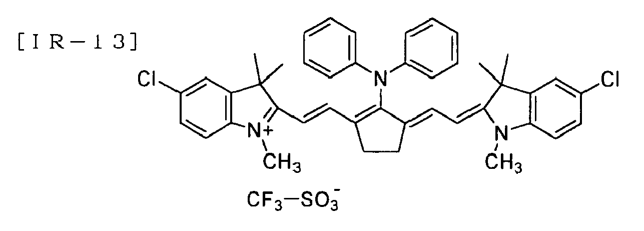

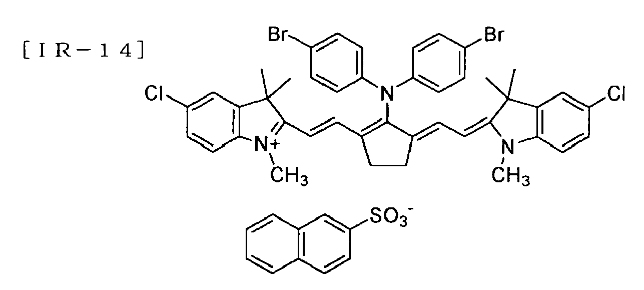

The pigment used can be a commercial pigment or a pigment as described in the Color Index (C.I.) reference work, "The Modern Pigment Handbook" (edited by the Japan Association of Pigment Technology (1977)), "Modern Pigment Applications Technology" (CMC (1986)), and "Printing Ink Technology" (CMC (1984)).

The pigment type can be exemplified by black pigments, yellow pigments, orange pigments, brown pigments, red pigments, purple pigments, blue pigments, green pigments, fluorescent pigments, and metal powder pigments and also by polymer-bonded colorants. The details of these pigments are particularly described in sections [0052] to [0054] of Japanese Patent Application Publication No. H10-39509A, and the pigments therein described can be used. Carbon black is preferred among these pigments.

The content of the aforementioned dye or pigment in the image recording layer, expressed in each instance with reference to the weight of the total solids fraction in the image recording layer, is preferably 0.01 to 50 % by weight and more preferably 0.1 to 10 % by weight, wherein 0.5 to 10 % by weight is most preferred for the dyes and 1.0 to 10 % by weight is most preferred for the pigments.

A low sensitivity may occur when this content is less than 0.01 % by weight, while at above 50 % by weight scumming may occur in the non-image areas once the lithographic printing plate precursor is made.

### (D) The binder polymer

The addition of a binder polymer to the image recording layer is preferred from the standpoint of improving the film properties. A linear organic polymer is preferably used as the binder. Any linear organic polymer may be used as this "linear organic polymer". A linear organic polymer that is soluble or swellable in water or weak aqueous alkali is preferably selected when it is desired to enable development with water or a weak aqueous alkali. The linear organic polymer used is selected not just as a film-forming agent for the formation of the image recording layer, but is also selected in conformity with the application, i.e., the use of water, weak aqueous alkali, or organic solvent for the developer. For example, development with water is made possible by the use of a water-soluble organic polymer. Such a linear organic polymer can be exemplified by radical polymers that have the carboxylic acid group in side chain position, for example, as described in Japanese Patent Application Publication No. S59-44615A, Japanese Patent Publication Nos. S54-34327, 58-12577, and 54-25957, and Japanese Patent Application Publication Nos. S54-92723A, 59-53836A, and 59-71048A, i.e., methacrylic acid copolymers, acrylic acid copolymers, itaconic acid copolymers, crotonic acid copolymers, maleic acid copolymers, partially esterified maleic acid copolymers, and so forth. Other examples are acidic cellulose derivatives that likewise have the carboxylic acid group in side chain position. In addition to the preceding, the adducts of a cyclic acid anhydride on an hydroxyl-functional polymer are also useful.

Among the preceding, (meth)acrylic resins having benzyl group or allyl group and the carboxyl group in side chain position are particularly suitable for their excellent balance among film strength, sensitivity, and developability.

In addition, the acid group-containing urethane-type binder polymers described in, for example, Japanese Patent Publication Nos. H7-12004, 7-120041, 7-120042, and 8-12424 and Japanese Patent Application Publication Nos. S63-287944A and 63-287947A and H1-271741A exhibit an extremely good strength and are thus advantageous in terms of their ability to printing durability and fitness for low photoexposure.

Other useful water-soluble linear organic polymers are polyvinylpyrrolidone, polyethylene oxide and so forth. Alcohol-soluble nylons, 2,2-bis(4-hydroxyphenyl)propane/epichlorohydrin polyethers and the like are also useful for raising the strength of the cured coating.

The polymer used has a weight-average molecular weight preferably of at least 5,000 and more preferably in the range from 10,000 to 300,000 and has a number-average molecular preferably of at least 1,000 and more preferably in the range from 2,000 to 250,000. The polydispersity (weight-average molecular weight/number-average molecular weight) is preferably 1 or more and more preferably is in the range of 1.1 to 10.

These polymers may be random polymers, block polymers, or graft polymers, and random polymers are preferred.

A single binder polymer may be used or a mixture of binder polymers may be used. This polymer is added to the image recording layer in a proportion of 20 to 95 % by weight and preferably 30 to 90 % by weight, in each instance with reference to the total solids fraction in the image recording layer coating solution. A quantity of addition of less than 20 % by weight results in a deficient strength for the image areas when image formation is carried out. Image formation does not occur when this quantity of addition exceeds 95 % by weight. The weight ratio between the radically polymerizable compound having an ethylenically unsaturated double bond and the linear organic polymer is preferably in the range from 1/9 to 7/3.

### Other components

In addition to the preceding, various other compounds may be added to the image recording layer on an optional basis. For example, a dye that exhibits substantial absorption in the visible region can be used as an image colorant. Specific examples are Oil Yellow #101, Oil Yellow #103, Oil Pink #312, Oil Green BG, Oil Blue BOS, Oil Blue #603, Oil Black BY, Oil Black BS, and Oil Black T-505 (all of the preceding from Orient Chemical Industries, Ltd.), as well as Victoria Pure Blue, Crystal Violet (CI42555), Methyl Violet (CI42535), Ethyl Violet, Rhodamine B (CI145170B), Malachite Green (CI42000), Methylene Blue (CI52015), and so forth, and also the dyes described in Japanese Patent Application Publication No. S62-293247A. Pigments such as phthalocyanine-type pigments, azo-type pigments, and titanium oxide can also be suitably used.

The addition of such a colorant is preferred because it enables facile discrimination after image formation of the image and non-image areas. Its quantity of addition is 0.01 to 10 % by weight with reference to the total solids fraction in the image recording layer coating solution.

When the image recording layer is a photopolymerizing layer, a small amount of a thermal polymerization inhibitor is desirably added in order to prevent inadvertent thermal polymerization, during preparation of the coating solution or during storage, of the radically polymerizable compound that contains the ethylenically unsaturated double bond. Examples of suitable thermal polymerization inhibitors are hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), N-nitroso-N-phenylhydroxylamine aluminum salt, and so forth. The quantity of addition for the thermal polymerization inhibitor is preferably about 0.01 % by weight to about 5 % by weight with reference to the total composition weight. In addition, for example, behenic acid, a higher fatty acid derivative such as behenamide, or an alcohol such as 1-docosanol may be added on an optional basis in order to lower the coefficient of friction of the image recording layer and prevent scratching; these segregate to the surface of the image recording layer during the drying process that follows coating.

In order to broaden the processing stability with respect to the development conditions, a nonionic surfactant as described in Japanese Patent Application Publication Nos. S62-251740A and H3-208514A or an amphoteric surfactant as described in Japanese Patent Application Publication Nos. S59-121044A and H4-13149A may be added to the image recording layer coating solution.

Specific examples of the nonionic surfactant are sorbitan tristearate, sorbitan monopalmitate, sorbitan trioleate, monoglyceride stearate, and polyoxyethylene nonylphenyl ether.

Specific examples of the amphoteric surfactant are alkyldi(aminoethyl)glycine, alkylpolyaminoethylglycine hydrochloride, 2-alkyl-N-carboxyethyl-N-hydroxyethylimidazolinium betaine, and N-tetradecyl-N,N-betaine types (for example, Amogen K (trade name), Daiichi Kogyo Seiyaku Co., Ltd.).

The proportion of the aforementioned nonionic surfactant or amphoteric surfactant in the image recording layer coating solution is preferably 0.05 to 15 % by weight and more preferably 0.1 to 5 % by weight.

A plasticizer may be added on an optional basis to the image recording layer coating solution in order, inter alia, to impart flexibility to the film coating. Examples here are polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, and so forth.

In order to produce the image recording material, the above-described individual components required for the image recording layer coating solution may generally be dissolved in a solvent and coated on a suitable support. The solvent used here can be exemplified by ethylene dichloride, cyclohexanone, methyl ethyl ketone, methyl isobutyl ketone, methanol, ethanol, propanol, ethylene glycol monomethyl ether, 1-methoxy-2-propanol, 1-methoxy-3-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyrolactone, toluene, water, and so forth, but there is no limitation to the preceding. A single solvent may be used or a mixture may be used. The concentration of the aforementioned components (total solids fraction including additives) in the solvent is preferably 1 to 50 % by weight.

The amount (solids) of the image recording layer coating on the support after coating and drying will vary with the application, but is generally preferably 0.5 to 5.0 g/m² for a lithographic printing plate precursor. Various coating methods can be used, for example, bar coater application, spin coating, spray coating, curtain coating, dip coating, air knife coating, blade coating, roll coating, and so forth. While the apparent sensitivity increases as the quantity of application declines, this also results in reduced film properties for the image recording layer that carries the image recording function.

### - Ultraviolet photopolymerizable photosensitive lithographic printing plates -

The general constituent components of the photosensitive layer of an ultraviolet photopolymerizable photosensitive lithographic printing plate are, inter alia, (a) an addition polymerizable compound that contains at least one ethylenically unsaturated double bond, (b) a polymer that is soluble in or swellable by an aqueous alkaline solution, and (c) a photopolymerization initiator system. Various other compounds may be added on an optional basis, for example, a colorant, plasticizer, thermal polymerization inhibitor, and so forth.

There are no particular limitations on the photopolymerizable photosensitive lithographic printing plates to which the plate surface protective agent of the present invention may be applied, and, for example, the plate surface protective agent of the present invention may be applied to the photopolymerizable photosensitive lithographic printing plates described in Japanese Patent Application Publication Nos. 2001-125255, 2001-183822, 2001-199174, 2001-228608, and 2006-276237. In particular, the photopolymerization initiator described in Japanese Patent Application Publication No. 2006-276237 (described in sections [0131] to [0138]) and the sensitizing dyes also described therein (described in sections [0139] to [0173]) are preferred, and the chain-transfer agent also described therein (described in sections [0174] to [0186]) may be added depending on the circumstances.

### [The support]

The support for the various photosensitive lithographic printing plates described in the preceding should be a dimensionally stable plate-shaped material but is not otherwise particularly limited; however, aluminum supports are preferred.

The aluminum support is selected from dimensionally stable aluminum and aluminum-containing alloys (for example, alloys between aluminum and a metal such as silicon, copper, manganese, magnesium, chromium, zinc, lead, bismuth, nickel, and so forth) in which aluminum is the principal component and from plastic films and paper on which aluminum or an aluminum alloy has been laminated or vapor deposited. The aluminum support may also be a composite sheet comprising an aluminum sheet bonded on polyethylene terephthalate film, as described in Japanese Patent Publication No. S48-18327. Suitable substrate surface treatments, infra, are executed on this aluminum support.

### (Graining treatment)

Graining treatment methods include electrolytic graining, chemical etching, and mechanical graining as disclosed in Japanese Patent Application Publication No. S56-28893A. Also usable are electrochemical graining methods in which electrochemical graining is executed in a hydrochloric acid or nitric acid electrolytic solution; wire brush graining methods in which the aluminum surface is abraded with metal wire; and mechanical graining methods, e.g., ball graining methods in which the aluminum surface is grained with polishing balls and polishing agent and brush graining methods in which the surface is grained with a nylon brush and a polishing agent. A single such graining method may be used or combinations of these graining methods may be used.

Among the preceding, electrochemical methods that execute chemical graining in a hydrochloric acid or nitric acid electrolytic solution are particularly effective methods for generating surface roughness; a suitable current density is the range from 100 C/dm² to 400 C/dm². In more specific terms, electrolysis is preferably carried out at a temperature of 20 to 100°C for 1 second to 30 minutes at a current density of 100 C/dm² to 400 C/dm² in an electrolytic solution containing 0.1 to 50% hydrochloric acid or nitric acid.

The thusly grained aluminum support is chemically etched with acid or base. Some time is required to break down the microstructure when acid is used as the etchant, which is disadvantageous with regard to application at an industrial level; however, this can be improved by the use of base as the etchant.

Bases suitable for use are sodium hydroxide, sodium carbonate, sodium aluminate, sodium metasilicate, sodium phosphate, potassium hydroxide, lithium hydroxide, and so forth, wherein the preferred concentration range is 1 to 50% and the preferred temperature range is 20 to 100°C. Conditions are preferred that provide at aluminum dissolution of 5 to 20 g/m³.

An acid wash is carried out to remove the smut remaining on the surface after etching. The acid used here is, for example, nitric acid, sulfuric acid, phosphoric acid, chromic acid, hydrofluoric acid, fluoroboric acid, and so forth. In particular, the method described in Japanese Patent Application Publication No. S53-12739A, comprising contact with 15 to 65 weight% sulfuric acid at a temperature of 50 to 90°C, and the base etching method described in Japanese Patent Publication No. S48-28123 are preferred for the desmutting procedure after electrochemical roughening.

For example, a surface roughness (Ra) for the Al support of 0.3 to 0.7 µm is effective.

### (Anodic oxidation)

The aluminum support treated as described above is additionally subjected to anodic oxidation.

This anodic oxidation can be carried out by the methods heretofore used in this field. In specific terms, an anodic oxidation film can be formed on the surface of the aluminum support when direct or alternating current is applied to the aluminum in an aqueous or nonaqueous solution of an inorganic acid (e.g., hydrochloric acid, sulfuric acid, phosphoric acid, nitric acid, chromic acid, boric acid, and so forth), organic acid (e.g., oxalic acid, sulfamic acid, benzenesulfonic acid, and so forth), or a combination of two or more of the preceding.

The conditions for the anodic oxidation treatment vary as a function of the electrolytic solution used and so cannot be unconditionally specified; however, in general an electrolytic solution concentration of 1 to 80%, a solution temperature of 5 to 70°C, a current density of 0.5 to 60 A/dm², a voltage of 1 to 100 V, and an electrolysis time of 10 to 100 seconds are suitable.

Preferred among these anodic oxidation treatments are the method of anodic oxidation at high current densities in sulfuric acid as described in British Patent No. 1,412,768 and the method of anodic oxidation using phosphoric acid as the electrolytic bath as described in United States Patent No. 3,511,661.

The anodic oxidation film is preferably 1 to 10 g/m²: the plate is easily scratched at less than 1 g/m², while large and economically disadvantageous amounts of power are required to produce films greater than 10 g/m². 1.5 to 7 g/m² is preferred and 2 to 5 g/m² is more preferred.

The aluminum support may also be sealed after the graining treatment and anodic oxidation. This sealing treatment is carried out, for example, using immersion of the substrate in hot water and in a hot aqueous solution containing an inorganic salt or organic salt, using a steam bath, and so forth. In addition, the aluminum support may be subjected to a silicate treatment with an alkali metal silicate and may be subjected to a surface treatment such as, for example, immersion in an aqueous solution of potassium fluorozirconate or a phosphate salt.

In addition to the above-described aluminum support, the following dimensionally stable plate-shaped materials are also suitably used for the support in the photosensitive lithographic printing plate: paper, paper laminated with plastic (e.g., polyethylene, polypropylene, polystyrene, and so forth), metal plates (e.g., zinc, copper, and so forth), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, and so forth), and paper or plastic film on which a metal as cited above has been laminated or vapor deposited.

A surface hydrophilization treatment is preferably also carried out on these supports in conformity to the particular support. Examples of this surface hydrophilization treatment include treatment by etching or a chemical reaction such as oxidation, reduction, or sol-gel coating, and coating with a special compound that adsorbs to the support surface.

### [The undercoating layer]

The photosensitive lithographic printing plate comprises at least one image forming layer or image recording layer laminated on a support, but an undercoating layer can be disposed on the support as necessary.

Various organic compounds can be employed as the components used for this undercoating layer, for example, carboxymethyl cellulose; dextrin; gum arabic; amino-functional phosphonic acids such as 2-aminoethylphosphonic acid; organophosphonic acids such as possibly substituted phenylphosphonic acid, naphthylphosphonic acid, alkylphosphonic acid, glycerophosphonic acid, methylenediphosphonic acid, and ethylenediphosphonic acid; organophosphates such as possibly substituted phenyl phosphate, naphthyl phosphate, alkyl phosphate, and glycerophosphate; organophosphinic acids such as possibly substituted phenylphosphinic acid, naphthylphosphinic acid, alkylphosphinic acid, and glycerophosphinic acid; amino acids such as glycine, β-alanine, and so forth; and the hydrochlorides of hydroxyl-functional amines such as triethanolamine hydrochloride.

A single one of these organic compounds may be used or a mixture of two or more may be used. The undercoating of a diazonium salt as described above is also a preferred embodiment.

Another preferred undercoating layer is an organic undercoating layer that contains at least one organic polymer compound that has a structural unit shown by general formula (V) below.

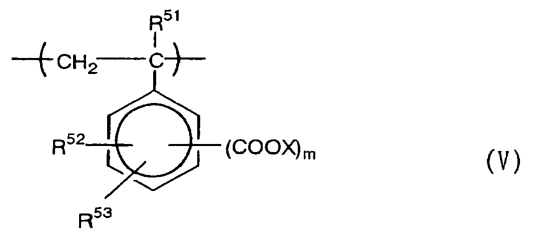

R⁵¹ in the formula represents the hydrogen atom, a halogen atom, or alkyl group; R⁵² and R⁵³ each independently represent the hydrogen atom, the hydroxyl group, a halogen atom, alkyl, substituted alkyl, aryl, substituted aryl, - OR54, -COOR⁵⁵, -CONHR⁵⁶, -COR⁵⁷, or -CN, or R⁵² and R⁵³ may be bonded to each other to form a cyclic structure. R⁵⁴ to R⁵⁷ each independently represent alkyl or aryl. X represents the hydrogen atom, a metal atom, or -NR⁵⁸R⁵⁹R⁶⁰R⁶¹_{.} R⁵⁸ to R⁶¹ each independently represent the hydrogen atom, alkyl, substituted alkyl, aryl, or substituted aryl, and R⁵⁸ and R⁵⁹ may be bonded to each other to form a cyclic structure. m is an integer from 1 to 3.

The dry coating quantity for the undercoating layer is preferably 2 to 200 mg/m² and more preferably is 5 to 100 mg/m². Acceptable film properties may not be obtained at a dry coating quantity of less than 2 mg/m². On the other hand, no additional effect is obtained for coating in excess of 200 mg/m².

The following, as other preferred examples, are also suitably undercoated: water-soluble resins, for example, polyvinylphosphonic acid, polymers and copolymers having the sulfo group in side chain position, and polyacrylic acid; water-soluble metal salts (for example, zinc borate); yellow dyes; amine salts; and so forth. Also suitable for use are sol-gel treated substrates that carry covalently bonded functional groups capable of causing a radical-mediated addition reaction, as disclosed in Japanese Patent Application Publication No. H7-159983A.

In another example, a water-resistant hydrophilic layer is disposed as a surface layer on any of the supports. Such a surface layer can be exemplified by a layer comprising inorganic pigment and binder, as described in United States Patent No. 3,055,295 and Japanese Patent Application Publication No. S56-13168A; the hydrophilic swelling layer described in Japanese Patent Application Publication No. H9-80744A; and the sol-gel film comprising titanium oxide, polyvinyl alcohol, and a silicic acid, as described in Published Japanese Translation No. H8-507727 of PCT International Publication. This hydrophilization treatment is carried out in order to render the surface of the support hydrophilic and also to prevent inhibitory reactions on the photosensitive layer disposed thereon as well as to improve the adherence of the photosensitive layer.

Other examples of the intermediate layer are described in Japanese Patent Publication No. S50-7481; Japanese Patent Application Publilcation Nos. S54-72104A, 59-101651A, 60-149491A, and 60-232998A; Japanese Patent Application Publication Nos. H3-56177A, 4-282637A, 5-16558A, 5-246171A, 7-314937A, 8-202025A, 8-320551A, 9-34104A, 9-236911A, 9-269593A, 10-69092A, 10-115931A, 10-161317A, 10-260536A, 10-282682A, 11-84674A, 11-38635A, 11-38629A, 10-282645A, 10-301262A, 11-24277A, 11-109641A, 10-319600A, and 11-327152A; and Japanese Patent Application Publication Nos. 2000-10292, 2000-235254, 2000-352824, and 2001-209170.

The undercoating layer can be provided by the following methods.

In one method, an undercoating layer solution is prepared by dissolving the aforementioned organic compound(s) in water or an organic solvent (e.g., methanol, ethanol, methyl ethyl ketone, and so forth) or a mixed solvent of the preceding and this undercoating layer solution is coated on the support, e.g., aluminum, and dried thereon. In another method, an undercoating layer solution is prepared by dissolving the aforementioned organic compound(s) in water or an organic solvent (e.g., methanol, ethanol, methyl ethyl ketone, and so forth) or a mixed solvent of the preceding; the support, e.g., aluminum, is immersed in this undercoating layer solution to adsorb the organic compound(s) thereon; and this is followed by washing, e.g., with water, and drying.

The use is preferred in the former method of an undercoating layer solution that has a concentration of the aforementioned organic compound(s) of 0.005 to 10 % by weight.

In the latter method, on the other hand, the concentration of the aforementioned organic compound(s) in the undercoating layer solution is suitably 0.01 to 20 % by weight and preferably is 0.05 to 10 % by weight and more preferably is 0.1 to 5 % by weight. The immersion temperature is preferably 20 to 90°C and more preferably is 25 to 50°C. The immersion time is preferably 0.1 second to 20 minutes and more preferably is 2 seconds to 1 minute. The undercoating layer solution can also be adjusted into the pH range of 1 to 12 using a base such as ammonia, triethylamine, potassium hydroxide, and so forth, or an acid such as hydrochloric acid, phosphoric acid, and so forth. A yellow dye may also be incorporated for the purposing of improving the tone reproducibility.

In one example of a lithographic printing plate produced using the plate surface protective agent according to the present invention, a backcoat layer is disposed on the back surface of the support for the photosensitive lithographic printing plate, that is, on the side opposite the side bearing the photosensitive layer.

The following are preferably used as this backcoat: the organic polymer compound described in Japanese Patent Application Publication No. H5-45885A and the coating layer comprising a metal oxide obtained by the hydrolysis and polycondensation of an organic or inorganic metal compound, as described in Japanese Patent Application Publication No. H6-35174A. Among these coating layers, the alkoxy compounds of silicon, e.g., Si(OCH₃)₄, Si(OC₂H₅)₄, Si(OC₃H₇)₄, Si(OC₄H₉)₄, and so forth, are particularly preferred because they are inexpensive and easily acquired and metal oxide coating layers obtained therefrom have an excellent resistance to developing solutions.

Further examples of organic polymer compounds contained in the backcoat layer are epoxy resins and the like. An example of another preferred embodiment is the combination of epoxy resin with at least one selection from rosin and phenolic hydroxyl-functional resins. Preferred for use thereamong is the combination of epoxy resin and rosin. A phenolic hydroxyl-functional resin may also be present. Other resins and additives may also be present in order to improve various properties of the backcoat layer.

### (The epoxy resin)

The epoxy resin used in the backcoat layer can be exemplified by the glycidyl ether compounds obtained by a reaction between epichlorohydrin and a polyhydric alcohol or polyhydric phenol and by the prepolymers of these glycidyl ether compounds, and also by the polymers and copolymers of glycidyl acrylate or methacrylate.

The following are specific examples of suitable compounds: propylene glycol diglycidyl ether, tripropylene glycol diglycidyl ether, polypropylene glycol diglycidyl ether, neopentyl glycol diglycidyl ether, trimethylolpropane triglycidyl ether, the diglycidyl ether of hydrogenated bisphenol A, hydroquinone diglycidyl ether, resorcinol diglycidyl ether, the diglycidyl ether or epichlorohydrin polyadduct of bisphenol A, the diglycidyl ether or epichlorohydrin polyadduct of bisphenol F, the diglycidyl ether or epichlorohydrin polyadduct of halogenated bisphenol A, the diglycidyl ether or epichlorohydrin polyadduct of a biphenyl-type bisphenol, the glycidyl ethers of novolac resins, methyl methacrylate/glycidyl methacrylate copolymers, ethyl methacrylate/glycidyl methacrylate copolymers, and so forth.

Examples of commercially available products of compounds of this type are as follows: jER1001 (molecular weight = approximately 900, epoxy equivalent weight = 450 to 500), jER1002 (molecular weight = approximately 1600, epoxy equivalent weight = 600 to 700), jER1004 (molecular weight = approximately 1060, epoxy equivalent weight = 875 to 975), jER1007 (molecular weight = approximately 2900, epoxy equivalent weight = 2000), jER1009 (molecular weight = approximately 3750, epoxy equivalent weight = 3000), jER1010 (molecular weight = approximately 5500, epoxy equivalent weight = 4000), jER1100L (epoxy equivalent weight = 4000), and jERYX31575 (epoxy equivalent weight = 1200), all from Japan Epoxy Resins Co., Ltd.; and Sumiepoxy ESCN-195XHN, ESCN-195X1, and ESCN-195XF, all from Sumitomo Chemical Co., Ltd.

The weight-average molecular weight of the epoxy resin, expressed on a polystyrene basis, is preferably at least 1,000. The weight-average molecular weight is more preferably 1,000 to 500,000, even more preferably is 1,000 to 200,000, and particularly preferably is 1,000 to 100,000.

The epoxy resin content in the backcoat layer is preferably in the range of 50 to 100 % by weight, more preferably in the range of 65 to 99 % by weight, and even more preferably in the range of 70 to 97.5 % by weight, in each instance expressed with reference to the total weight of the backcoat layer.

The rosin used in the backcoat layer can be, for example, a natural rosin such as gum rosin, tall oil rosin, wood rosin, and so forth; a rosin polymer derived from the aforementioned natural rosins; a stabilized rosin obtained by the disproportionation or hydrogenation of the aforementioned natural rosins and rosin polymers; or an unsaturated acid-modified rosin obtained by the addition of an unsaturated carboxylic acid to the aforementioned natural rosins and rosin polymers. The unsaturated acid-modified rosin can be exemplified by maleic acid-modified rosin, maleic anhydride-modified rosin, fumaric acid-modified rosin, itaconic acid-modified rosin, crotonic acid-modified rosin, cinnamic acid-modified rosin, acrylic acid-modified rosin, and methacrylic acid-modified rosin, and also by the acid-modified rosin polymers corresponding to the preceding.

Preferred for use among these rosins are rosin-modified phenolic resins and rosin esters.

The following can preferably be used as the aforementioned rosin esters: Super Ester E-720, Super Ester E-730-55, Super Ester E-650, Super Ester E-786-60, Tamanol E-100, Emulsion AM-1002, and Emulsion SE-50 (all trade names, all specialty rosin ester emulsions, Arakawa Chemical Industries, Ltd.), and also Super Ester L, Super Ester A-18, Super Ester A-75, Super Ester A-100, Super Ester A-115, Super Ester A-125, and Super Ester T-125 (all trade names, all specialty rosin esters, Arakawa Chemical Industries, Ltd.).

The following can also preferably be used as the rosin esters: Ester Gum AAG, Ester Gum AAL, Ester Gum A, Ester Gum AAV, Ester Gum 105, Ester Gum HS, Ester Gum AT, Ester Gum H, Ester Gum HP, Ester Gum HD, Pensel A, Pensel AD, Pensel AZ, Pensel C, Pensel D-125, Pensel D-135, Pensel D-160, and Pensel KK (all trade names, all rosin ester-type resins, Arakawa Chemical Industries, Ltd.).

The following can preferably be used as the aforementioned rosin-modified phenolic resin: Tamanol 135, Tamanol 145, Tamanol 340, Tamanol 350, Tamanol 351, Tamanol 352, Tamanol 353, Tamanol 354, Tamanol 359, Tamanol 361, Tamanol 362, Tamanol 366, Tamanol 374, Tamanol 379, Tamanol 380, Tamanol 381, Tamanol 384, Tamanol 386, Tamanol 387, Tamanol 388, Tamanol 392, Tamanol 394, Tamanol 395, Tamanol 396, Tamanol 405, Tamanol 406, Tamanol 409, Tamanol 410, Tamanol 414, and Tamanol 415 (all trade names, all rosin-modified phenolic resins, Arakawa Chemical Industries, Ltd.).

Other rosin examples are as follows: Rondis R, Rondis K-25, Rondis K-80, and Rondis K-18 (all trade names, all rosin derivatives, Arakawa Chemical Industries, Ltd.) and Pinecrystal KR-85, Pinecrystal KR-612, Pinecrystal KR-614, Pinecrystal KE-100, Pinecrystal KE-311, Pinecrystal KE-359, Pinecrystal KE-604, Pinecrystal 30PX, Pinecrystal D-6011, Pinecrystal D-6154, Pinecrystal D-6240, Pinecrystal KM-1500, and Pinecrystal KM-1550 (all trade names, all extremely lightly colored rosin derivatives, Arakawa Chemical Industries, Ltd.).

The weight-average molecular weight of the rosin, expressed on a polystyrene basis, is preferably at least 1,000. The weight-average molecular weight is more preferably 1,000 to 500,000, even more preferably 1,000 to 200,000, and particularly preferably 1,000 to 100,000.

The rosin content in the backcoat layer is preferably in the range of 0 to 50 % by weight, more preferably in the range of 1 to 35 % by weight, and even more preferably in the range of 2.5 to 30 % by weight, in each instance expressed with reference to the total weight of the backcoat layer.

The phenolic hydroxyl-functional resin used in the backcoat layer can be exemplified by novolac resins, e.g., condensation polymers from phenol and formaldehyde, condensation polymers from m-cresol and formaldehyde, condensation polymers from p-cresol and formaldehyde, condensation polymers from m-/p-cresol mixtures and formaldehyde, and condensation polymers from phenol, cresol (m-cresol or p-cresol or a m-/p-cresol mixture), and formaldehyde, and can also be exemplified by pyrogallol resins that are condensation polymers from pyrogallol and acetone.

Copolymers obtained by the copolymerization of phenolic hydroxyl-functional compounds may also be used as the phenolic hydroxyl-functional resin.

Such phenolic hydroxyl-functional compounds can be exemplified by phenolic hydroxyl-functional acrylamides, methacrylamides, acrylate esters, and methacrylate esters and by hydroxystyrene.

Viewed from the perspective of the film properties, the weight-average molecular weight of the phenolic hydroxyl-functional resin, expressed on a polystyrene basis, is preferably at least 1,000. The weight-average molecular weight is more preferably 1,000 to 500,000, even more preferably 1,000 to 200,000, and particularly preferably 1,000 to 100,000.

Based on considerations of the film properties and the ability to resist adhesion to the surfacemost face of the photosensitive recording layer, the content of the phenolic hydroxyl-functional resin in the backcoat layer is preferably in the range of 0.1 to 90 % by weight, more preferably in the range of 0.1 to 50 % by weight, and even more preferably in the range of 0.5 to 30 % by weight, in each instance with reference to the total weight of the backcoat layer.

The backcoat layer may additionally incorporate an organic or inorganic polymer compound in order to improve the film properties and may as necessary incorporate a plasticizer, surfactant, and other additives in order to impart flexibility and/or adjust the slickness.

In order, inter alia, to improve the chemical resistance, the backcoat layer can additionally incorporate an o-naphthoquinonediazide compound, photosensitive azide compound, photopolymerizable composition having as its main component monomer that contains an unsaturated double bond, cinnamic acid or a dimethylmaleimide group-containing photocrosslinkable compound, or a diazo resin yielded by the condensation in an acidic medium of a diazonium salt monomer or aromatic diazonium salt and a reactive carbonyl-functional organic condensing agent (particularly an aldehyde such as formaldehyde, acetaldehyde, and so forth, or an acetal). Among the preceding, the use is preferred of an o-naphthoquinonediazide compound known as a positive-acting photosensitive compound.

The backcoat layer can be elaborated by hot-press bonding a film or by melt lamination or by a coating method, but coating from a solution is more preferred from the standpoint of efficiently elaborating a thin film. Accordingly, the resin used in the backcoat layer is preferably noncrystalline and readily soluble in the various industrial organic solvents. The coating quantity for the backcoat layer, expressed as the weight after drying, is preferably in the range of 0.01 to 10 g/m², more preferably 0.05 to 7 g/m², and even more preferably 0.1 to 5 g/m².

### [Photoexposure]

The lithographic printing plate precursor obtained as described above is subjected to imagewise photoexposure. The light source for the actinic light used in this imagewise photoexposure can be exemplified by mercury lamps, metal halide lamps, xenon lamps, chemical lamps, carbon arc lamps, and so forth. Examples of radiation are electron beams, x-rays, ion beams, far-infrared radiation, and so forth. Also usable are the g-line, i-line, deep UV radiation, and high energy density beams (laser beams). For example, a helium-neon laser, argon laser, krypton laser, helium-cadmium laser, KrF excimer laser, and so forth can be used for the laser beam. For laser direct-writing printing plates, a light source is preferred that emits light at wavelengths from the near infrared to the infrared region, and solid lasers and semiconductor lasers are particularly preferred.

After photoexposure, the aforementioned lithographic printing plate precursor is developed using a heretofore used alkaline developing solution. As necessary, photoexposure may be followed by a heating treatment prior to development. There are no particular limitations on the alkaline developing solution used or on the developing conditions used, and suitable selections here in conformity with the sensitive material can be used.

After development, the plate is treated with the plate surface protective agent according to the present invention as described above.

### EXAMPLES

The present invention is described by examples in the following, but the present invention is not limited to these.

### Preparation of the plate surface protective agent

The individual plate surface protective agents 1 to 28 were prepared using the compositions (unit: g) shown in Tables 1 to 5 below.

These plate surface protective agents were evaluated for liquid separation. Specifically, the plate surface protective agent was introduced into a transparent glass flask and heated to 45°C and the status of liquid separation was visually observed after the passage of three days and was scored on the following scale. The results are shown in the lower section of Tables 1 to 5.

⊗: Separation does not occur.

○: A slight amount of floating material occurs at the surface, but this is unproblematic.

○Δ: Slight layer separation is seen at the surface; however, separation disappears upon shaking; unproblematic for use.

Δ: Layer separation occurs at the surface; however, layer separation disappears upon shaking; unproblematic for use.

×: Separates into two layers; separation remains even upon shaking; produces problems for use after long-term standing.

Foaming by the plate surface protective agent was also investigated. Specifically, the following were compared after the plate surface protective agent had been prepared: foaming during filling into a tank (for example, the 5 L-tank for the GN-2K from Fuji Film Co., Ltd.), and foaming when introduced into an LP-1310HII automatic developer (Fuji Film Co., Ltd.) and circulated for 15 minutes. The results are shown in the lower section of Tables 1 to 5.

A: There is almost no foam when filled into the tank and almost no foam when circulated in the automatic developer; the foaming behavior is unproblematic.

B: Foam is seen during filling into the tank and during circulation in the automatic developer; however, the foaming behavior is unproblematic.

C: Large amount of foam during filling into the tank; however, this is unproblematic when the productivity is reduced and filling is done slowly. While foam is observed during circulation in the automatic developer, the foaming behavior is unproblematic.

D: Severe foaming occurs during filling into the tank and during circulation in the automatic developer, and the foaming behavior is unfit for practical use.

### Fingerprint scumming test

Fingerprint scumming was evaluated on lithographic printing plates made from the photopolymerizable lithographic printing plates using the plate surface protective agents referenced above.

### [Evaluation procedure]

A fingerprint was placed in a non-image area of the lithographic printing plate, which was then stored overnight at a temperature of 35°C and a humidity of 85%. It was then mounted in an offset press and printing was started. A comparison was done of the number of sheets until fingerprint scumming in the fingerprinted area disappeared and a normal impression was obtained. The smaller this number of sheets, the better due to the absence of consumption of wasted paper. The results are shown in the lower section of Tables 1 to 5.

Here is the preparation procedure of photopolymerizable lithographic printing plate precursor used and platemaking process therefrom.

### Fabrication of photopolymerizable lithographic printing plates and platemaking

### (Production of the support)

The surface treatment shown below was carried out on JIS A 1050 aluminum plate having a thickness of 0.30 mm and a width of 1030 mm.

### <Surface treatment>

The following treatments (a) to (f) were carried out in sequence for the surface treatment. The liquid was drained off with a nip roller after each treatment and water wash.
(a) The aluminum plate was etched at a temperature of 70°C, a sodium hydroxide concentration of 26 % by weight, and an aluminum ion concentration of 6.5 % by weight. 5 g/m² of the aluminum plate was dissolved. This was followed by a water wash.
(b) Desmutting was carried out by spraying with a 1 % by weight aqueous nitric acid solution (contained 0.5 % by weight aluminum ion) at a temperature of 30°C. This was followed by a water wash.
(c) A continuous electrochemical roughening treatment was carried out using 60 Hz alternating-current voltage. The electrolytic solution here was a 1 % by weight aqueous nitric acid solution (contained 0.5 % by weight aluminum ion and 0.007 % by weight ammonium ion) and the temperature was 30°C. An electrochemical surface roughening treatment was carried out using a carbon electrode for the counterelectrode and an alternating-current power source that provided a trapezoidal rectangular wave alternating current with a TP (time for the current value to go from zero to its peak) of 2 msec and a duty ratio of 1 : 1. Ferrite was used for the auxiliary anode. The current density was 25 A/dm² at the peak current value and the amount of electricity was 250 C/cm² as the sum of the electricity when the aluminum plate was functioning as an anode. The auxiliary anode received 5% of the current output from the power source. This was followed by a water wash.
(d) The aluminum plate was etched spraying at 35°C using a sodium hydroxide concentration of 26 % by weight and an aluminum ion concentration of 6.5 % by weight. 0.2 g/m² of the aluminum plate was dissolved. This removed the smut components (mainly aluminum hydroxide) produced during the alternating-current electrochemical roughening in the preceding step and also dissolved the edge regions of the produced pits to thereby smooth out the edge regions. This was followed by a water wash.
(e) A desmutting treatment was carried out by spraying a 25 % by weight aqueous sulfuric acid solution (contained 0.5 % by weight aluminum ion) at 60°C. This was followed by a water wash.
(f) An anodic oxidation treatment was carried out for 50 seconds using a sulfuric acid concentration of 170 g/L (contained 0.5 % by weight aluminum ion), a temperature of 33°C, and a current density of 5 (A/dm²). This was followed by a water wash. The anodic oxidation film weight in this case was 2.7 g/m².

The surface roughness Ra, surface area ratio ΔS, and steepness a45 of the resulting aluminum support were as follows: Ra = 0.27 (measurement instrument: Surfcom from Tokyo Seimitsu Co., Ltd., stylus tip diameter = 2 µm), ΔS = 75%, a45 = 44% (measurement instrument: SPA300/SPI3800N from Seiko Instruments Inc.).

### (Formation of the undercoating layer)

Using a wire bar, the following undercoating layer-forming coating solution was then applied on the side of the aluminum support that had been subjected to the surface treatment. Drying was carried out for 30 seconds at 90°C. The coated quantity was 10 mg/m².

### < The undercoating layer-forming coating solution >

- polymer compound A with the structure given 0.05 g below (weight average molecular weight: 10,000)
- methanol 27 g
- ion-exchanged water 3 g

### Polymer compound A

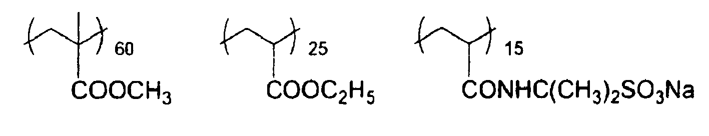

### (Formation of the photosensitive layer)

A photosensitive layer-forming coating solution A, infra, was prepared and was coated using a wire bar on the undercoating layer that had been formed as described above. Drying was carried out for 34 seconds at 125°C with a hot-air dryer. The coated amount after drying was 1.4 g/m².

### < Photosensitive layer-forming coating solution A >

- infrared absorber (IR-1) 0.038 g
- polymerization initiator A (S-1) 0.061 g
- polymerization initiator B (I-1) 0.094 g
- mercapto compound (E-1) 0.015 g
- polymerizable compound (M-1) 0.425 g (trade name: A-BPE-4, from Shin-Nakamura Chemical Co., Ltd.)
- binder polymer A (B-1) 0.311 g
- binder polymer B (B-2) 0.250 g
- binder polymer C (B-3) 0.062 g
- additive (T-1) 0.079 g
- polymerization inhibitor (Q-1) 0.0012 g
- Ethyl Violet (EV-1) 0.021 g
- fluorosurfactant 0.0081 g
   (Megaface F-780-F, Dainippon Ink & Chemicals,
   30 % by weight methyl isobutyl ketone (MIBK) solution)
- methyl ethyl ketone 5.886 g
- methanol 2.733 g
- 1-methoxy-2-propanol 5.886 g

The structures of the infrared absorber (IR-1), polymerization initiator A (S-1), polymerization initiator B (I-1), mercapto compound (E-1), polymerizable compound (M-1), binder polymer A (B-1), binder polymer B (B-2), binder polymer C (B-3), additive (T-1), polymerization inhibitor (Q-1), and Ethyl Violet (EV-1) used in this photosensitive layer-forming coating solution A are shown below.

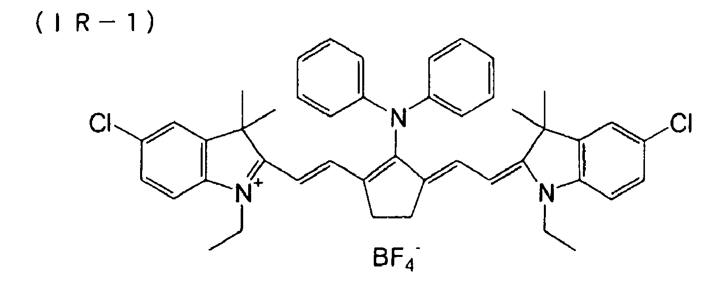

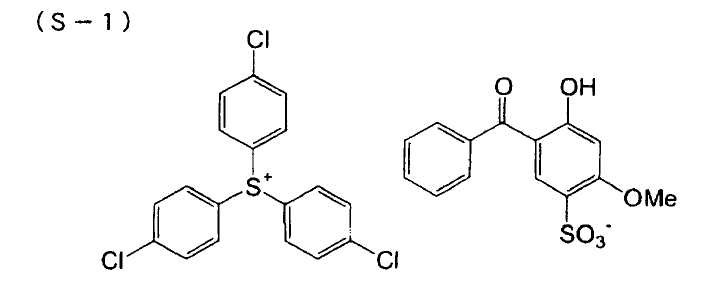

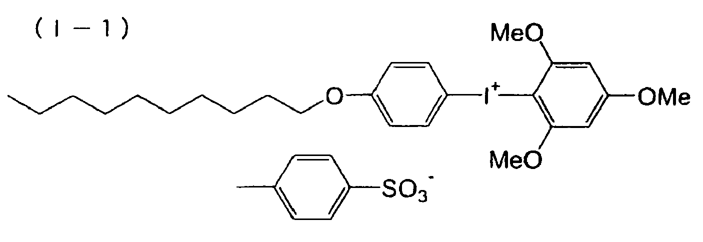

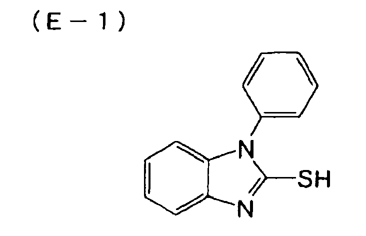

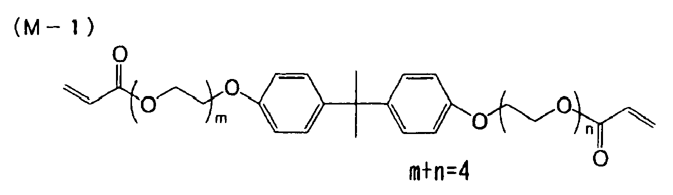

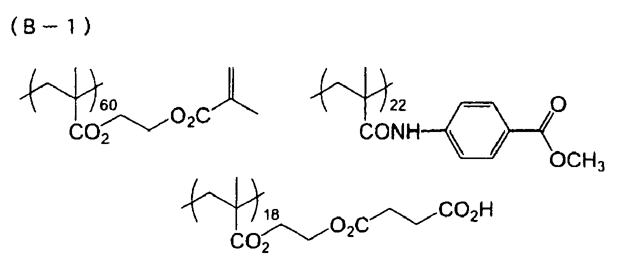

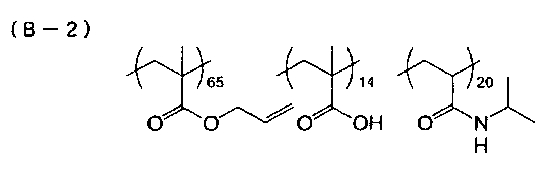

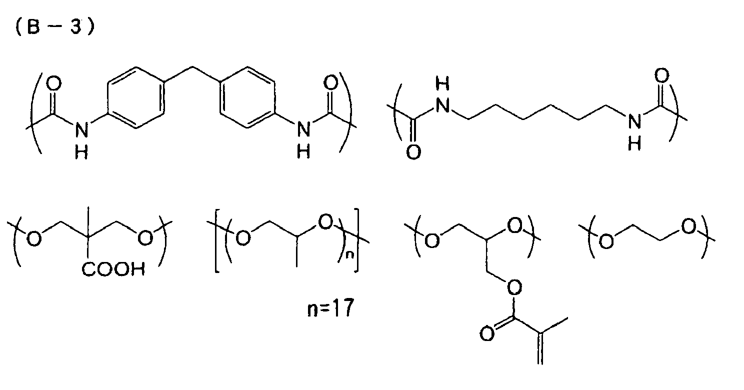

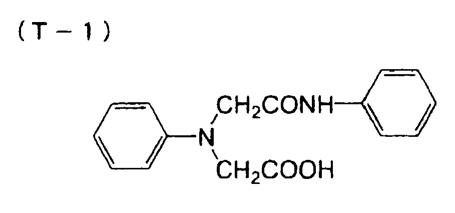

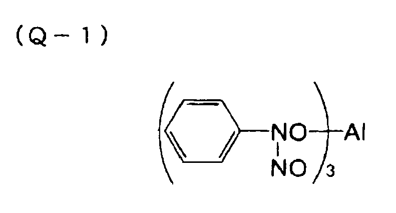

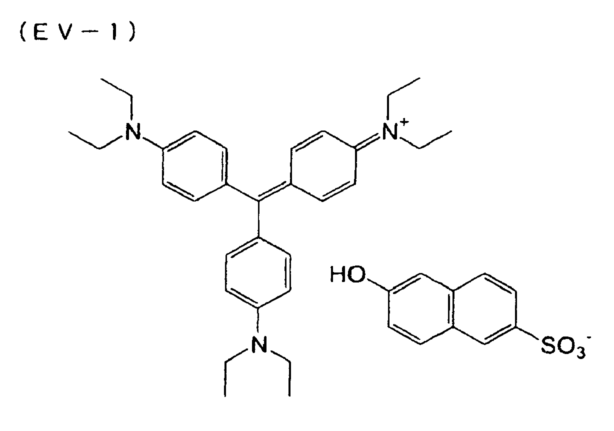

### (Formation of the lower protective layer)

On the photosensitive layer thus formed was applied, using a wire bar, a mixed aqueous solution (the lower protective layer-forming coating solution) of synthetic mica (Somashif MEB-3L, 3.2% aqueous dispersion, from Co-op Chemical Co., Ltd.), polyvinyl alcohol (Gohselan CKS-50, degree of saponification = 99 mol%, degree of polymerization = 300, sulfonic acid-modified polyvinyl alcohol, Nippon Synthetic Chemical Industry Co., Ltd.), surfactant A (Nihon Emulsion Co., Ltd., Emalex 710), and surfactant B (Adeka Pluronic P-84, Adeka Corporation). Drying was carried out for 30 seconds at 125°C in a forced convection dryer.

The synthetic mica (solids)/polyvinyl alcohol/surfactant A/surfactant B proportions in this mixed aqueous solution (lower protective layer-forming coating solution), expressed as % by weight, were 7.5/89/2/1.5, and the coating quantity (amount of coating after drying) was 0.5 g/m².

### (Formation of the upper protective layer)

On the lower protective layer thus formed was coated, using a wire bar, a mixed aqueous solution (the upper protective layer-forming coating solution) of organic filler (Art Pearl J-7P, Negami Chemical Industrial Co., Ltd.), synthetic mica (Somashif MEB-3L, 3.2% aqueous dispersion, from Co-op Chemical Co., Ltd.), polyvinyl alcohol (L-3266, degree of saponification = 87 mol%, degree of polymerization = 300, sulfonic acid-modified polyvinyl alcohol, Nippon Synthetic Chemical Industry Co., Ltd.), thickener (Cellogen FS-B, Dai-ichi Kogyo Seiyaku Co., Ltd.), polymer compound A (structure given above), and surfactant (Nihon Emulsion Co., Ltd., Emalex 710). Drying was carried out for 30 seconds at 125°C in a forced convection dryer.

The organic filler/synthetic mica (solids)/polyvinyl alcohol/thickener/polymer compound A/surfactant proportions in this mixed aqueous solution (upper protective layer-forming coating solution), expressed as % by weight, were 4.7/2.8/67.4/18.6/2.3/4.2, and the coating quantity (amount of coating after drying) was 1.2 g/m².

The thereby obtained lithographic printing plate precursor was transported from the setting section by an autoloader to a Trendsetter 3244 (Creo) and was exposed to a 50% screen tint image at a resolution of 2400 dpi, output of 7 W, outer drum rotation rate of 150 rpm, and plate surface energy of 110 mJ/cm². A heat treatment and water wash were not carried out after exposure, while development was carried using an LP-1310HII automatic developer from Fuji Film Co., Ltd., at a transport speed (line speed) of 2 m/minute and a development temperature of 30°C. A 1 : 4 aqueous dilution of DH-N was used as the developing solution and a 1 : 1.4 aqueous dilution of FCT-421 was used as the development replenishing solution. Plate surface protective agents 1 to 28 in Tables 1 to 5 were used as the plate surface protective agent. Lithographic printing plates were obtained having a plate surface protective layer at a coating quantity of 0.25 g/m².

The fingerprint scumming test described above was carried out on these lithographic printing plates.

**Table 1**

| | Examples | | | | | |
|---|---|---|---|---|---|---|
| | 1 | 2 | 3 | 4 | 5 | 6 |
| Plate surface protective agent No. | 1 | 2 | 3 | 4 | 5 | 6 |
| Pure water | 900 | 900 | 900 | 900 | 900 | 900 |
| Hydroxypropyl cellulose | 90 | 90 | 90 | 90 | 90 | 90 |
| Gum arabic | 30 | 30 | 30 | 30 | 30 | 30 |
| Phosphate esterified starch | 10 | 10 | 10 | 10 | 10 | 10 |
| compound with general formula (I) | | | | | | |
| A: R=C₁₄H₂₉-, n=20 | 9 | - | - | - | - | - |
| B: R=C₁₄H₂₉-, n=30 | - | 9 | - | - | - | - |
| C: R=C₁₄H₂₉-, n=40 | - | - | 9 | - | - | - |
| D: R=C₁₄H₂₉-, n=50 | - | - | - | 9 | - | - |
| E: R=C₁₄H₂₉-, n=60 | - | - | - | - | 9 | - |
| F: R=C₁₆H₃₃-, n=20 | - | - | - | - | - | 9 |
| G: R=C₁₆H₃₃-, n=30 | - | - | - | - | - | - |
| H: R=C₁₆H₃₃-, n=40 | - | - | - | - | - | - |
| I: R=C₁₆H₃₃-, n=50 | - | - | - | - | - | - |
| J: R=C₁₆H₃₃-, n=60 | - | - | - | - | - | - |
| K: R=C₁₈H₃₇-, n=20 | - | - | - | - | - | - |
| L: R=C₁₈H₃₇-, n=30 | - | - | - | - | - | - |
| M: R=C₁₈H₃₇-, n=40 | - | - | - | - | - | - |
| N: R=C₁₈H₃₇-, n=50 | - | - | - | - | - | - |
| O: R=C₁₈H₃₇-, n=60 | - | - | - | - | - | - |
| P: R=C₂₂H₄₅-, n=20 | - | - | - | - | - | - |
| Q: R=C₂₂H₄₅-, n=30 | - | - | - | - | - | - |
| R: R=C₂₂H₄₅-, n=40 | - | - | - | - | - | - |
| S: R=C₂₂H₄₅-, n=50 | - | - | - | - | - | - |
| T: R=C₂₂H₄₅-, n=60 | - | - | - | - | - | - |
| a: R=C₁₂H₂₅-, n=30 | - | - | - | - | - | - |
| b: R=C₁₂H₂₅-, n=40 | - | - | - | - | - | - |
| c: R=C₁₆H₃₃-, n=10 | - | - | - | - | - | - |
| d: R=C₁₆H₃₃-, n=70 | - | - | - | - | - | - |
| e: R=C₁₈H₃₇-, n=10 | - | - | - | - | - | - |
| f: R=C₁₈H₃₇-, n=70 | - | - | - | - | - | - |
| g: R=C₂₄H₄₉-, n=30 | - | - | - | - | - | - |
| h: R=C₂₄H₄₉-, n=40 | - | - | - | - | - | - |
| Sodium dioctyl sulfosuccinate | 1 | 1 | 1 | 1 | 1 | 1 |
| Primary ammonium phosphate | 0.8 | 0.8 | 0.8 | 0.8 | 0.8 | 0.8 |
| Phosphoric acid | 3 | 3 | 3 | 3 | 3 | 3 |
| Mixture of sodium lauryl diphenyl ether di-and monosulfonates (trade name: Eleminol MON2, Sanyo Chemical Industries, Ltd.) | 2 | 2 | 2 | 2 | 2 | 2 |
| Propylene glycol | 5 | 5 | 5 | 5 | 5 | 5 |
| Benzyl alcohol | 9 | 9 | 9 | 9 | 9 | 9 |
| 5-Chloro-2-methyl-3-isothiazolone | 0.03 | 0.03 | 0.03 | 0.03 | 0.03 | 0.03 |
| 2-Methyl-3-isothiazolone | 0.01 | 0.01 | 0.01 | 0.01 | 0.01 | 0.01 |
| Bromonitropropanediol | 0.03 | 0.03 | 0.03 | 0.03 | 0.03 | 0.03 |
| 2-Phosphono-1,2,4-butane-tricarboxylic acid | 0.8 | 0.8 | 0.8 | 0.8 | 0.8 | 0.8 |
| Dimethylsilicone | 0.1 | 0.1 | 0.1 | 0.1 | 0.1 | 0.1 |
| Liquid separation | ○ | ⊗ | ⊗ | ⊗ | ⊗ | ○ |
| Foaming behavior | A | A | A | B | C | A |
| Fingerprint scumming | 40 | 20 | 20 | 20 | 15 | 15 |

**Table 2**

| | Examples | | | | | |
|---|---|---|---|---|---|---|
| | 7 | 8 | 9 | 10 | 11 | 12 |
| Plate surface protective agent No. | 7 | 8 | 9 | 10 | 11 | 12 |
| Pure water | 900 | 900 | 900 | 900 | 900 | 900 |
| Hydroxypropyl cellulose | 90 | 90 | 90 | 90 | 90 | 90 |
| Gum arabic | 30 | 30 | 30 | 30 | 30 | 30 |
| Phosphate esterified starch | 10 | 10 | 10 | 10 | 10 | 10 |
| Compound with general formula (I) | | | | | | |
| A: R=C₁₄H₂₉-, n=20 | - | - | - | - | - | - |
| B: R=C₁₄H₂₉-, n=30 | - | - | - | - | - | - |
| C: R=C₁₄H₂₉-, n=40 | - | - | - | - | - | - |
| D: R=C₁₄H₂₉-, n=50 | - | - | - | - | - | - |
| E: R=C₁₄H₂₉-, n=60 | - | - | - | - | - | - |
| F: R=C₁₆H₃₃-, n=20 | - | - | - | - | - | - |
| G: R=C₁₆H₃₃-, n=30 | 9 | - | - | - | - | - |
| H: R=C₁₆H₃₃-, n=40 | - | 9 | - | - | - | - |
| I: R=C₁₆H₃₃-, n=50 | - | - | 9 | - | - | - |
| J: R=C₁₆H₃₃-, n=60 | - | - | - | 9 | - | - |
| K: R=C₁₈H₃₇-, n=20 | - | - | - | - | 9 | - |
| L: R=C₁₈H₃₇-, n=30 | - | - | - | - | - | 9 |
| M: R=C₁₈H₃₇-, n=40 | - | - | - | - | - | - |
| N: R=C₁₈H₃₇-, n=50 | - | - | - | - | - | - |
| O: R=C₁₈H₃₇-, n=60 | - | - | - | - | - | - |
| P: R=C₂₂H₄₅-, n=20 | - | - | - | - | - | - |
| Q: R=C₂₂H₄₅-, n=30 | - | - | - | - | - | - |
| R: R=C₂₂H₄₅-, n=40 | - | - | - | - | - | - |
| S: R=C₂₂H₄₅-, n=50 | - | - | - | - | - | - |
| T: R=C₂₂H₄₅-, n=60 | - | - | - | - | - | - |
| a: R=C₁₂H₂₅-, n=30 | - | - | - | - | - | - |
| b: R=C₁₂H₂₅-, n=40 | - | - | - | - | - | - |
| c: R=C₂₄H₄₉⁻, n=30 | - | - | - | - | - | - |
| d: R=C₂₄H₄₉⁻, n=40 | - | - | - | - | - | - |
| e: R=C₁₆H₃₃⁻, n=10 | - | - | - | - | - | - |
| f: R=C₁₆H₃₃⁻, n=70 | - | - | - | - | - | - |
| g: R=C₁₈H₃₇⁻, n=10 | - | - | - | - | - | - |
| h: R=C₁₈H₃₇⁻, n=70 | - | - | - | - | - | - |
| Sodium dioctyl sulfosuccinate | 1 | 1 | 1 | 1 | 1 | 1 |
| Primary ammonium phosphate | 0.8 | 0.8 | 0.8 | 0.8 | 0.8 | 0.8 |
| Phosphoric acid | 3 | 3 | 3 | 3 | 3 | 3 |
| Mixture of sodium lauryl diphenyl ether di-and monosulfonates (trade name: Eleminol MON2, Sanyo Chemical Industries, Ltd.) | 2 | 2 | 2 | 2 | 2 | 2 |
| Propylene glycol | 5 | 5 | 5 | 5 | 5 | 5 |
| Benzyl alcohol | 9 | 9 | 9 | 9 | 9 | 9 |
| 5-Chloro-2-methyl-3-isothiazolone | 0.03 | 0.03 | 0.03 | 0.03 | 0.03 | 0.03 |
| 2-Methyl-3-isothiazolone | 0.01 | 0.01 | 0.01 | 0.01 | 0.01 | 0.01 |
| bromonitropropanediol | 0.03 | 0.03 | 0.03 | 0.03 | 0.03 | 0.03 |
| 2-Phosphono-1,2,4-butane-tricarboxylic acid | 0.8 | 0.8 | 0.8 | 0.8 | 0.8 | 0.8 |
| Dimethylsilicone | 0.1 | 0.1 | 0.1 | 0.1 | 0.1 | 0.1 |
| Liquid separation | ⊗ | ⊗ | ⊗ | ⊗ | ○ | ⊗ |
| Foaming behavior | A | A | B | C | A | A |
| Fingerprint scumming | 5 | 5 | 5 | 5 | 15 | 5 |

**Table 3**

| | Examples | | | | | |
|---|---|---|---|---|---|---|
| | 13 | 14 | 15 | 16 | 17 | 18 |
| Plate surface protective agent No. | 13 | 14 | 15 | 16 | 17 | 18 |
| Pure water | 900 | 900 | 900 | 900 | 900 | 900 |
| Hydroxypropyl cellulose | 90 | 90 | 90 | 90 | 90 | 90 |
| Gum arabic | 30 | 30 | 30 | 30 | 30 | 30 |
| Phosphate esterified starch | 10 | 10 | 10 | 10 | 10 | 10 |
| Compound with general formula (I) | | | | | | |
| A: R=C₁₄H₂₉⁻, n=20 | - | - | - | - | - | - |
| B: R=C₁₄H₂₉-, n=30 | - | - | - | - | - | - |
| C: R=C₁₄H₂₉-, n=40 | - | - | - | - | - | - |
| D: R=C₁₄H₂₉-, n=50 | - | - | - | - | - | - |
| E: R=C₁₄H₂₉-, n=60 | - | - | - | - | - | - |
| F: R=C₁₆H₃₃-, n=20 | - | - | - | - | - | - |
| G: R=C₁₆H₃₃-, n=30 | - | - | - | - | - | - |
| H: R=C₁₆H₃₃-, n=40 | - | - | - | - | - | - |
| I: R=C₁₆H₃₃-, n=50 | - | - | - | - | - | - |
| J: R=C₁₆H₃₃-, n=60 | - | - | - | - | - | - |
| K: R=C₁₈H₃₇-, n=20 | - | - | - | - | - | - |
| L: R=C₁₈H₃₇-, n=30 | - | - | - | - | - | - |
| M: R=C₁₈H₃₇-, n=40 | 9 | - | - | - | - | - |
| N: R=C₁₈H₃₇-, n=50 | - | 9 | - | - | - | - |
| O: R=C₁₈H₃₇-, n=60 | - | - | 9 | - | - | - |
| P: R=C₂₂H₄₅-, n=20 | - | - | - | 9 | - | - |
| Q: R=C₂₂H₄₅-, n=30 | - | - | - | - | 9 | - |
| R: R=C₂₂H₄₅-, n=40 | - | - | - | - | - | 9 |
| S: R=C₂₂H₄₅-, n=50 | - | - | - | - | - | - |
| T: R=C₂₂H₄₅-, n=60 | - | - | - | - | - | - |
| a: R=C₁₂H₂₅-, n=30 | - | - | - | - | - | - |
| b: R=C₁₂H₂₅-, n=40 | - | - | - | - | - | - |
| c: R=C₂₄H₄₉-, n=30 | - | - | - | - | - | - |
| d: R=C₂₄H₄₉-, n=40 | - | - | - | - | - | - |
| e: R=C₁₆H₃₃-, n=10 | - | - | - | - | - | - |
| f: R=C₁₆H₃₃-, n=70 | - | - | - | - | - | - |
| g: R=C₁₈H₃₇-, n=10 | - | - | - | - | - | - |
| h: R=C₁₈H₃₇-, n=70 | - | - | - | - | - | - |
| Sodium dioctyl sulfosuccinate | 1 | 1 | 1 | 1 | 1 | 1 |
| Primary ammonium phosphate | 0.8 | 0.8 | 0.8 | 0.8 | 0.8 | 0.8 |
| Phosphoric acid | 3 | 3 | 3 | 3 | 3 | 3 |
| Mixture of sodium lauryl diphenyl ether di-and monosulfonates (trade name: Eleminol MON2, Sanyo Chemical Industries, Ltd.) | 2 | 2 | 2 | 2 | 2 | 2 |
| Propylene glycol | 5 | 5 | 5 | 5 | 5 | 5 |
| Benzyl alcohol | 9 | 9 | 9 | 9 | 9 | 9 |
| 5-Chloro-2-methyl-3-isothiazolone | 0.03 | 0.03 | 0.03 | 0.03 | 0.03 | 0.03 |
| 2-Methyl-3-isothiazolone | 0.01 | 0.01 | 0.01 | 0.01 | 0.01 | 0.01 |
| Bromonitropropanediol | 0.03 | 0.03 | 0.03 | 0.03 | 0.03 | 0.03 |
| 2-Phosphono-1,2,4-butane-tricarboxylic acid | 0.8 | 0.8 | 0.8 | 0.8 | 0.8 | 0.8 |
| Dimethylsilicone | 0.1 | 0.1 | 0.1 | 0.1 | 0.1 | 0.1 |
| Liquid separation | ⊗ | ⊗ | ⊗ | ○Δ | ○ | ○ |
| Foaming behavior | A | B | C | A | A | A |
| Fingerprint scumming | 5 | 5 | 5 | 40 | 20 | 20 |

**Table 4**

| | Examples | | Comparative examples | | | |
|---|---|---|---|---|---|---|
| | 19 | 20 | 1 | 2 | 3 | 4 |
| Plate surface protective agent No. | 19 | 20 | 21 | 22 | 23 | 24 |
| Pure water | 900 | 900 | 900 | 900 | 900 | 900 |
| Hydroxypropyl cellulose | 90 | 90 | 90 | 90 | 90 | 90 |
| Gum arabic | 30 | 30 | 30 | 30 | 30 | 30 |
| Phosphate esterified starch | 10 | 10 | 10 | 10 | 10 | 10 |
| Compound with general formula (I) | | | | | | |
| A: R=C₁₄H₂₉-, n=20 | - | - | - | - | - | - |
| B: R=C₁₄H₂₉-, n=30 | - | - | - | - | - | - |
| C: R=C₁₄H₂₉-, n=40 | - | - | - | - | - | - |
| D: R=C₁₄H₂₉-, n=50 | - | - | - | - | - | - |
| E: R=C₁₄H₂₉-, n=60 | - | - | - | - | - | - |
| F: R=C₁₆H₃₃-, n=20 | - | - | - | - | - | - |
| G: R=C₁₆H₃₃-, n=30 | - | - | - | - | - | - |
| H: R=C₁₆H₃₃-, n=40 | - | - | - | - | - | - |
| I: R=C₁₆H₃₃-, n=50 | - | - | - | - | - | - |
| J: R=C₁₆H₃₃-, n=60 | - | - | - | - | - | - |
| K: R=C₁₈H₃₇-, n=20 | - | - | - | - | - | - |
| L: R=C₁₈H₃₇-, n=30 | - | - | - | - | - | - |
| M: R=C₁₈H₃₇-, n=40 | - | - | - | - | - | - |
| N: R=C₁₈H₃₇-, n=50 | - | - | - | - | - | - |
| O: R=C₁₈H₃₇-, n=60 | - | - | - | - | - | - |
| P: R=C₂₂H₄₅-, n=20 | - | - | - | - | - | - |
| Q: R=C₂₂H₄₅-, n=30 | - | - | - | - | - | - |
| R: R=C₂₂H₄₅-, n=40 | - | - | - | - | - | - |
| S: R=C₂₂H₄₅-, n=50 | 9 | - | - | - | - | - |
| T: R=C₂₂H₄₅-, n=60 | - | 9 | - | - | - | - |
| a: R=C₁₂H₂₅-, n=30 | - | - | 9 | - | - | - |
| b: R=C₁₂H₂₅-, n=40 | - | - | - | 9 | - | - |
| c: R=C₂₄H₄₉-, n=30 | - | - | - | - | 9 | - |
| d: R=C₂₄H₄₉-, n=40 | - | - | - | - | - | 9 |
| e: R=C₁₆H₃₃-, n=10 | - | - | - | - | - | - |
| f: R=C₁₆H₃₃-, n=70 | - | - | - | - | - | - |
| g: R=C₁₈H₃₇-, n=10 | - | - | - | - | - | - |
| h: R=C₁₈H₃₇-, n=70 | - | - | - | - | - | - |
| Sodium dioctyl sulfosuccinate | 1 | 1 | 1 | 1 | 1 | 1 |
| Primary ammonium phosphate | 0.8 | 0.8 | 0.8 | 0.8 | 0.8 | 0.8 |
| Phosphoric acid | 3 | 3 | 3 | 3 | 3 | 3 |
| Mixture of sodium lauryl diphenyl ether di-and monosulfonates (trade name: Eleminol MON2, Sanyo Chemical Industries, Ltd.) | 2 | 2 | 2 | 2 | 2 | 2 |
| Propylene glycol | 5 | 5 | 5 | 5 | 5 | 5 |
| Benzyl alcohol | 9 | 9 | 9 | 9 | 9 | 9 |
| 5-Chloro-2-methyl-3-isothiazolone | 0.03 | 0.03 | 0.03 | 0.03 | 0.03 | 0.03 |
| 2-Methyl-3-isothiazolone | 0.01 | 0.01 | 0.01 | 0.01 | 0.01 | 0.01 |
| Bromonitropropanediol | 0.03 | 0.03 | 0.03 | 0.03 | 0.03 | 0.03 |
| 2-Phosphono-1,2,4-butane- | 0.8 | 0.8 | 0.8 | 0.8 | 0.8 | 0.8 |
| tricarboxylic acid | | | | | | |
| Dimethylsilicone | 0.1 | 0.1 | 0.1 | 0.1 | 0.1 | 0.1 |
| Liquid separation | ○ | ⊗ | ⊗ | ⊗ | × | × |
| Foaming behavior | B | C | A | A | A | A |
| Fingerprint scumming | 20 | 15 | 80 | 100 | 25 | 25 |

**Table 5**

| | Comparative examples | | | |
|---|---|---|---|---|
| | 5 | 6 | 7 | 8 |
| Plate surface protective agent No. | 25 | 26 | 27 | 28 |
| Pure water | 900 | 900 | 900 | 900 |
| Hydroxypropyl cellulose | 90 | 90 | 90 | 90 |
| Gum arabic | 30 | 30 | 30 | 30 |
| Phosphate esterified starch | 10 | 10 | 10 | 10 |
| Compound with general formula (I) | | | | |
| A: R=C₁₄H₂₉-, n=20 | - | - | - | - |
| B: R=C₁₄H₂₉-, n=30 | - | - | - | - |
| C: R=C₁₄H₂₉-, n=40 | - | - | - | - |
| D: R=C₁₄H₂₉-, n=50 | - | - | - | - |
| E: R=C₁₄H₂₉-, n=60 | - | - | - | - |
| F: R=C₁₆H₃₃-, n=20 | - | - | - | - |
| G: R=C₁₆H₃₃-, n=30 | - | - | - | - |
| H: R=C₁₆H₃₃₋, n=40 | - | - | - | - |
| I: R=C₁₆H₃₃-, n=50 | - | - | - | - |
| J: R=C₁₆H₃₃-, n=60 | - | - | - | - |
| K: R=C₁₈H₃₇-, n=20 | - | - | - | - |
| L: R=C₁₈H₃₇-, n=30 | - | - | - | - |
| M: R=C₁₈H₃₇-, n=40 | - | - | - | - |
| N: R=C₁₈H₃₇-, n=50 | - | - | - | - |
| O: R=C₁₈H₃₇-, n=60 | - | - | - | - |
| P: R=C₂₂H₄₅-, n=20 | - | - | - | - |
| Q: R=C₂₂H₄₅-, n=30 | - | - | - | - |
| R: R=C₂₂H₄₅-, n=40 | - | - | - | - |
| S: R=C₂₂H₄₅-, n=50 | - | - | - | - |
| T: R=C₂₂H₄₅-, n=60 | - | - | - | - |
| a: R=C₁₂H₂₅-, n=30 | - | - | - | - |
| b: R=C₁₂H₂₅-, n=40 | - | - | - | - |
| c: R=C₂₄H₄₉-, n=30 | - | - | - | - |
| d: R=C₂₄H₄₉-, n=40 | - | - | - | - |
| e: R=C₁₆H₃₃-, n=10 | 9 | - | - | - |
| f: R=C₁₆H₃₃-, n=70 | - | 9 | - | - |
| g: R=C₁₈H₃₇-, n=10 | - | - | 9 | - |
| h: R=C₁₈H₃₇-, n=70 | - | - | - | 9 |
| Sodium dioctyl sulfosuccinate | 1 | 1 | 1 | 1 |
| Primary ammonium phosphate | 0.8 | 0.8 | 0.8 | 0.8 |
| Phosphoric acid | 3 | 3 | 3 | 3 |
| Mixture of sodium lauryl diphenyl ether di-and monosulfonates (trade name: Eleminol MON2, Sanyo Chemical Industries, Ltd.) | 2 | 2 | 2 | 2 |
| Propylene glycol | 5 | 5 | 5 | 5 |
| Benzyl alcohol | 9 | 9 | 9 | 9 |
| 5-Chloro-2-methyl--3-isothiazolone | 0.03 | 0.03 | 0.03 | 0.03 |
| 2-Methyl-3-isothiazolone | 0.01 | 0.01 | 0.01 | 0.01 |
| Bromonitropropanediol | 0.03 | 0.03 | 0.03 | 0.03 |
| 2-Phosphono-1,2,4-butane-tricarboxylic acid | 0.8 | 0.8 | 0.8 | 0.8 |
| Dimethylsilicone | 0.1 | 0.1 | 0.1 | 0.1 |
| Liquid separation | Δ | ⊗ | × | ⊗ |
| Foaming behavior | A | D | A | D |
| Fingerprint scumming | 70 | 5 | 80 | 5 |

According to the test results provided above, the plate surface protective agent of the present invention does not undergo liquid separation and also exhibits restrained foaming. Moreover, even when a fingerprint is present during storage, a lithographic printing plate treated with the plate surface protective agent of the present invention can provide a normal impression at low paper consumptions when printing is carried out, and it is therefore clear that this plate surface protective agent provides an excellent capacity to prevent fingerprint scumming.

## Claims

1. A lithographic printing plate surface protective agent, comprising at least one compound represented by the following general formula (I):
R-O-(CH₂CH₂O)ₙ-H (I)
wherein R is a C₁₄ to C₂₂ alkyl group and n is an average number of moles of addition of an ethylene oxide group and is 20 to 60.

2. The lithographic printing plate surface protective agent according to claim 1, wherein n in the general formula (I) is 30 to 50.

3. The lithographic printing plate surface protective agent according to claim 1, wherein n in the general formula (I) is 30 to 40.

4. The lithographic printing plate surface protective agent according to any of claims 1 to 3, wherein R in the general formula (I) is a C₁₆ or C₁₈ alkyl group.

5. A platemaking method for a lithographic printing plate, comprising:
subjecting a photosensitive lithographic printing plate precursor having a photopolymerizable photosensitive layer on a support, said photopolymerizable photosensitive layer containing a photopolymerization initiator and a compound having an ethylenically unsaturated bond, to imagewise photoexposure and development, and thereafter to treatment with the lithographic printing plate surface protective agent according to any of claims 1 to 4.
